(19) **Europäisches Patentamt**
**European Patent Office**
**Office européen des brevets**

(11) **EP 4 152 038 B1**

(12) **EUROPÄISCHE PATENTSCHRIFT**

(45) Veröffentlichungstag und Bekanntmachung des Hinweises auf die Patenterteilung:
**02.07.2025 Patentblatt 2025/27**

(51) Internationale Patentklassifikation (IPC):
**G01R 33/565** (2006.01)

(52) Gemeinsame Patentklassifikation (CPC):
**G01R 33/56572; G01R 33/56518**

(21) Anmeldenummer: **21196773.2**

(22) Anmeldetag: **15.09.2021**

(54) **VERFAHREN, VORRICHTUNGEN UND SYSTEM ZUR KORREKTUR EINER WIRKUNG EINES STÖREFFEKTS AUF EIN GRADIENTENSYSTEM**

METHOD, DEVICES AND SYSTEM FOR CORRECTING AN IMPACT OF A DISTURBANCE EFFECT ON A GRADIENT SYSTEM

PROCÉDÉ, DISPOSITIFS ET SYSTÈME DE CORRECTION D'UN EFFET D'INTERFÉRENCE SUR UN SYSTÈME DE GRADIENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**22.03.2023 Patentblatt 2023/12**

(73) Patentinhaber: **Siemens Healthineers AG**
**91301 Forchheim (DE)**

(72) Erfinder:
• **Richter, Julian**
**97294 Unterpleichfeld (DE)**
• **Stich, Manuel**
**92711 Parkstein (DE)**
• **Dederichs, Richard**
**91093 Heßdorf (DE)**

(74) Vertreter: **Siemens Healthineers**
**Patent Attorneys**
**Postfach 22 16 34**
**80506 München (DE)**

(56) Entgegenhaltungen:
**EP-A1- 3 543 722  US-B1- 6 369 572**

• **JENNIFER NUSSBAUM ET AL.: "Nonlinearity and thermal effects in gradient chains: a cascade analysis based on current and field sensing", PROCEEDINGS OF THE INTERNATIONAL SOCIETY FOR MAGNETIC RESONANCE IN MEDICINE, ISMRM, 27TH ANNUAL MEETING AND EXHIBITION, MONTRÉAL, QUÉBEC, CANADA, 11 MAY - 16 MAY 2019, no. 213, 26 April 2019 (2019-04-26), XP040707600**
• **RAHMER JÜRGEN ET AL: "Non-Cartesian k-space trajectory calculation based on concurrent reading of the gradient amplifiers' output currents", MAGNETIC RESONANCE IN MEDICINE, vol. 85, no. 6, 18 February 2021 (2021-02-18), US, pages 3060 - 3070, XP055873969, ISSN: 0740-3194, Retrieved from the Internet <URL:https://onlinelibrary.wiley.com/doi/full-xml/10.1002/mrm.28725> DOI: 10.1002/mrm.28725**
• **GOORA FRÉDÉRIC G ET AL: "Arbitrary magnetic field gradient waveform correction using an impulse response based pre-equalization technique", JOURNAL OF MAGNETIC RESONANCE, ACADEMIC PRESS, ORLANDO, FL, US, vol. 238, 15 November 2013 (2013-11-15), pages 70 - 76, XP028670722, ISSN: 1090-7807, DOI: 10.1016/J.JMR.2013.11.003**

- JENNIFER NUSSBAUM ET AL.: "Improved thermal modelling and prediction of gradient response using sensor placement guided by infrared photography", PROCEEDINGS OF THE INTERNATIONAL SOCIETY FOR MAGNETIC RESONANCE IN MEDICINE, ISMRM, JOINT ANNUAL MEETING ISMRM-ESMRMB, PARIS, FRANCE, 16-21 JUNE 2018, no. 4210, 1 June 2018 (2018-06-01), XP040703418

- BENJAMIN EMANUEL DIETRICH ET AL.: "Thermal Variation and Temperature-Based Prediction of Gradient Response", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, no. 79, 7 April 2017 (2017-04-07), XP040687647

**Beschreibung**

Die Erfindung betriff ein Verfahren zur Korrektur einer Wirkung eines Störeffekts auf ein Gradientensystem einer Magnetresonanzvorrichtung bei einer Magnetresonanzmessung. Weiterhin betrifft die Erfindung eine Magnetresonanzvorrichtung und ein Magnetresonanzsystem mit einer Korrektureinrichtung.

In einem Magnetresonanzsystem wird üblicherweise ein Untersuchungsobjekt mit Hilfe eines Grundfeldmagnetsystems einem Grundfeldmagnetfeld mit einer Magnetfeldstärke zwischen 0,5 Tesla und 7 Tesla ausgesetzt. Bei Anlegen des Grundfeldmagnetfelds richten sich Atomkerne in dem Untersuchungsobjekt mit einem nicht verschwindenden nuklearen magnetischen Dipolmoment, häufig auch Spin genannt, entlang des Grundfeldmagnetfelds aus. Ein solches, kollektives Verhalten der Spins wird auf einer makroskopischen Ebene auch als "Magnetisierung" bezeichnet. Die Magnetisierung ist die Vektorsumme aller mikroskopischen magnetischen Momente im Objekt an einem bestimmten Ort.

Zusätzlich zu dem Grundfeldmagnetfeld wird mit Hilfe eines Gradientensystems ein Magnetfeldgradient angelegt, durch den die Magnetresonanzfrequenz (Larmor-Frequenz) am jeweiligen Ort bestimmt wird. Über eine Hochfrequenz-Sendeeinheit werden dann mittels geeigneter Antenneneinrichtungen hochfrequente Anregungssignale oder Hochfrequenzfelder (HF-Pulse) ausgesendet, was dazu führen soll, dass die Spins bestimmter, durch dieses Hochfrequenzfeld resonant (d. h. bei der am jeweiligen Ort vorliegenden Larmor-Frequenz) angeregter Atomkerne um einen definierten Flipwinkel gegenüber den Magnetfeldlinien des Grundmagnetfelds verkippt werden. Wirkt ein solcher HF-Puls auf Spins, welche bereits angeregt sind, so können diese in eine andere Winkelstellung umgekippt oder sogar in einen Ausgangszustand parallel zum Grundmagnetfeld zurückgeklappt werden. Bei der Relaxation der angeregten Spins werden Hochfrequenzsignale, so genannte Magnetresonanzsignale, resonant abgestrahlt. Diese Magnetresonanzsignale können mittels geeigneter Empfangsantennen (Antenneneinrichtungen, auch Magnetresonanzspulen oder Empfangsspulen genannt) empfangen und anschließend demoduliert, digitalisiert und als sogenannte "Rohdaten" weiterverarbeitet werden. Das Empfangen der Magnetresonanzsignale erfolgt in einem Ortsfrequenzraum, dem sogenannten "k-Raum", wobei während einer Magnetresonanzmessung **z.** B. eine Schicht des k-Raum entlang einer durch die Schaltung der Gradientenpulse definierten "Gradiententrajektorie" (auch "k-Raum-Trajektorie" genannt) zeitlich durchlaufen wird. Dabei werden zeitlich passend koordiniert die HF-Pulse ausgesandt. Aus den akquirierten Rohdaten lassen sich schließlich mittels einer zweidimensionalen Fourier-Transformation Bilddaten des Untersuchungsobjekts rekonstruieren. Alternativ können inzwischen auch dreidimensionale Volumen definiert, angeregt und ausgelesen werden, wobei die Rohdaten wiederum nach weiteren Verarbeitungsschritten in einen dreidimensionalen k-Raum einsortiert werden. Eine Rekonstruktion von dreidimensionalen Bilddaten kann entsprechend mittels einer dreidimensionalen Fourier-Transformation erfolgen.

Typischerweise werden zur Ansteuerung eines Magnetresonanzsystems bei einer Durchführung einer Magnetresonanzmessung bestimmte Abfolgen von HF-Pulsen und Gradientenpulsen, sogenannte Pulssequenzen, verwendet. Die Pulssequenzen können in verschiedenen Raumrichtungen und/oder Auslesezeitfenstern ausgespielt werden, währenddessen die Empfangsantennen auf Empfang geschaltet sind und die Magnetresonanzsignale empfangen.

Die Gradientenpulse sind üblicherweise über eine Gradientenamplitude, eine Gradientenpulszeitdauer und über eine Flankensteilheit bzw. die erste Ableitung der Pulsform dG/dt der Gradientenpulse ("Slew Rate") definiert. Da das Gradientensystem eine maximale Belastungsgrenze aufweist, sind eine Stärke sowie die Slew Rate der Gradientenpulse grundsätzlich limitiert.

Mit Hilfe eines sogenannten Messprotokolls werden die erwähnten Pulssequenzen für eine gewünschte Untersuchung, zum Beispiel einen bestimmten Kontrast der berechneten Bilder, vorab parametrisiert. Das Messprotokoll kann auch weitere Steuerdaten für die Magnetresonanzmessung enthalten. Grundsätzlich gibt es eine Vielzahl von Möglichkeiten, wie die Pulssequenzen aufgebaut sein können, um erwünschte Bilddaten des Untersuchungsobjekts zu erhalten.

Unter "Magnetresonanzaufnahmen" sollen im Folgenden mit Hilfe einer im Rahmen des Verfahrens angesteuerten Magnetresonanzvorrichtung erzeugte Bilddaten von einem Inneren eines Untersuchungsobjekts verstanden werden, aber auch Parameterkarten, welche eine räumliche oder zeitliche Verteilung von bestimmten Parameterwerten innerhalb des Untersuchungsobjekts wiedergeben und z. B. aus den Bilddaten erzeugt werden können. Unter einer "Aufnahme" von Magnetresonanzbilddaten wird dabei das Durchführen einer Magnetresonanzmessung mit Hilfe eines Magnetresonanzsystems verstanden.

Wie oben beschrieben, werden bei der Magnetresonanzmessung zunächst Magnetresonanzsignale gemessen, deren Amplitude als Fourier-Transformierte der Bilddaten im k-Raum interpretiert werden. Der k-Raum kann dabei als ein Ortsfrequenz-Raum einer Dichteverteilung der magnetischen Momente in einem zu untersuchenden Bereich aufgefasst werden, in welchem Magnetresonanzsignale erfasst werden. Wird der k-Raum ausreichend genau abgetastet, so lässt sich mittels einer (bei schichtweiser Abtastung zweidimensionale) Fourier-Transformation die räumliche Verteilung der Dichte der magnetischen Momente erhalten. Üblicherweise wird der k-Raum dabei linienweise entlang eines kartesischen Gitters abgetastet. Daneben sind jedoch auch andere Abtastmuster vorstellbar.

Bei der Magnetresonanzmessung hat die Genauigkeit des Ausspielens der Gradientenpulse durch das Gradientensystem einen starken Einfluss auf die Qualität von erfassten Bilddaten. Neben Pulssequenzen mit kartesischen Trajektorien der Gradientenpulse können auch solche Pulssequenzen mit radialen oder spiralförmigen Trajektorien verwendet werden. Darüber hinaus werden auch sogenannte Single-Shot-EPI-Sequenzen für Magnetresonanzmessungen eingesetzt. Letztere Sequenzen haben höhere Ansprüche an die zeitliche Genauigkeit der Magnetfeldgradienten. Ursachen für Abweichungen zwischen ausgespielten Gradientenpulsen und den erwarteten Gradientenpulsen finden sich beispielsweise in einem Auftreten von Wirbelströmen, Zeitabstimmungs- und Verstärkungsfehlern sowie Feldfluktuationen, welche durch mechanische Vibrationen nach einem Umschalten von Magnetfeldgradienten verursacht werden, aber auch in einer thermischen Variation und/oder einem nicht-linearen Verhalten von Hardware-Komponenten, wie z. B. einem Verstärker und/oder einer Gradientenspule des Gradientensystems. Solche Störeffekte führen zu Gradientenverläufen, welche von den erwarteten Gradientenverläufen abweichen. Diese Abweichung führt zu Fehlern bei der Ermittlung der k-Raum-Trajektorie, Fehlern in dem akquirierten Signal und schließlich zu Artefakten in den Bilddaten.

Sind die Abweichungen genau bekannt, so kann eine tatsächliche k-Raum-Trajektorie ermittelt und für die Rekonstruktion von Bilddaten verwendet werden. Alternativ kann die tatsächliche k-Raum-Trajektorie auch gemessen werden. Üblicherweise erfolgt eine Korrektur von Gradientenpulsen für einen spezifischen Gradientensystemzustand bei einer einzigen Temperatur. Beispielsweise wird eine Gradientensystem-Übertragungsfunktion einmal für die Raumtemperatur ermittelt und dann für die gesamte Bildgebungssequenz verwendet, ohne einen Temperaturwechsel während der Bildgebung zu berücksichtigen.

Die einmalige, statische Gradientenkorrektur basiert auf einer Technik, welche sich einer Übertragungsfunktion, wie einer Gradienten-Impuls-Antwortfunktion (GIRF *"Gradient Impulse Response Function"*) oder einer Gradientensystem-Übertragungsfunktion (GSTF *"Gradient System Transfer Function"*) gemäß Gleichung (1) bedient, um Abweichungen zu korrigieren. Dabei ist F die Fourier-Transformierte, f die Frequenz und t die Zeit.

$$GSTF(f) = F\{GIRF(t)\} \qquad (1)$$

Hierbei werden lineare und zeit-invariante Charakteristiken des dynamischen Gradientensystems genutzt, um ausgespielte Gradientenpulse während der Bildrekonstruktion zu korrigieren. Bei einer Technik wird die Gradienten-Impuls-Antwortfunktion GIRF oder die Gradientensystem-Übertragungsfunktion GSTF des Magnetresonanzsystems genutzt, um nicht-kartesische Trajektorien zu korrigieren. Durch die Verwendung der Gradientensystem-Übertragungsfunktion GSTF lässt sich dabei insbesondere ein Verhalten des gesamten Gradientensystems charakterisieren.

Bei einer sogenannten Post-Korrektur werden korrigierte Gradientenpulse $g_{post,l}(t)$ für jede Achse (l = x, y, z) mittels Multiplizierens der Fourier-Transformierten des nominellen Gradienten $G_{nom,l}(f)$ mit entsprechenden Gradientensystem-Übertragungsfunktionen bei einem konkreten Temperaturzustand $GSTF_{l,l}(f)$ sowie einer Fouriertransformation in die Zeitdomäne (Rücktransformation) berechnet:

$$g_{post,l}(t) = F^{-1}\{F\{g_{nom,l}(t)\} \cdot GSTF_{l,l}(f)\} \qquad (2)$$

Der Wert "l" repräsentiert die Richtung x, y, z, in welche ein Eingabe-Gradient $g_{nom,l}(t)$, auch nomineller Gradient genannt, ausgespielt wurde und in welcher ein Ausgabe-Gradient $G_{real,l}$ (f) gemessen wird.

Alternativ wird bei einer vorausgehenden Entzerrung (sogenannten "pre-emphasis") die inverse Gradienten-Impuls-Antwortfunktion oder Gradientensystem-Übertragungsfunktion genutzt. Hierbei kann ein korrigierter, nomineller Gradientenpuls $g_{pre,l}(t)$ ausgespielt werden, welcher dem erwünschten, nominellen Gradientenpuls $g_{nom,l}$ entspricht, sodass ein erwünschter Ausgabe-Gradient $G_{real,l}(t)$ erzielt wird:

$$g_{pre,l}(t) = F^{-1}\{F\{g_{nom,l}(t)\} \cdot GSTF_{l,l}^{-1}(f)\} \qquad (3)$$

Die Gleichungen 2 und 3 zeigen vereinfachte Korrekturen der Gradientenpulse, wobei nur Selbstterme erster Ordnung der Gradientensystem-Übertragungsfunktion verwendet werden. Zur Erläuterung soll hier kurz erwähnt sein, dass die Gradientensystem-Übertragungsfunktion auch Terme, welche Wechselwirkungen zwischen Magnetfeldkomponenten unterschiedlicher Richtungen beschreiben, sowie Terme höherer Ordnung, umfasst. Um eine umfängliche und vollständige Korrektur durchzuführen, müssen alle Terme der Gradientensystem-Übertragungsfunktion von der 0-ten bis zur n-ten Ordnung verwendet werden. Eine hinreichende Korrektur kann allerdings bereits dadurch erreicht werden, dass hauptsächlich die Terme 0-ter Ordnung verwendet werden, um die Grundmagnetfelder ($B_0$-Felder) zu korrigieren, und die Terme erster Ordnung verwendet werden, um die Magnetfeldgradienten zu korrigieren. Bei der Bestimmung der Gradientensystem-Übertragungsfunktion sollte das Gradientensystem mit einem breiten Frequenzspektrum geprüft werden. Idealerweise wird als Testgradientenfunktion ein Dirac-Impuls herangezogen, um eine Abdeckung sämtlicher Frequenzen zu erreichen.

Die Gradientenpulse, welche durch das Gradientensystem der Magnetresonanzvorrichtung ausgespielt werden, werden üblicherweise in kleinen dynamischen Feldproben ("field probes") gemessen, mit denen eine Phasentwicklung bzw. ein Phasensignal bestimmbar ist. Das Phasensignal basiert auf einem Rohsignal, also dem Signal, welches von den Empfangsantennen gemessen wird. Von dem Rohsignal wird nur die Phase weiterverarbeitet. Die Magnitude wird dabei außer Acht gelassen. Aus dem Phasensignal lässt sich der Gradient bestimmen.

Die Korrektur von Gradientenpulsen ist somit bereits bekannt. Allerdings beschränken sich bekannte Techniken auf eine der Akquisition von Magnetresonanzsignalen nachgelagerte Korrektur von k-Raum Daten oder auf eine Korrektur von konstant während des Ablaufs einer Magnetresonanzaufnahme auftretenden Störeffekten. Eine Kompensation eines dynamischen, insbesondere nicht-linearen, Verhaltens von Komponenten des Gradientensystem der Magnetresonanzvorrichtung während Magnetresonanzmessung wird bislang nicht berücksichtigt.

Nussbaum et al. schlagen vor, eine Gradientenkette in eine Kaskade bestehend aus Wirbelstromkompensation, Verstärker und Spule zu unterteilen. Einflüsse des Verstärkers und der Spule lassen sich mittels Feldmessungen durch Strommessung trennen, und Linearität und Zeit-Varianz Verstöße werden durch Erwärmungsexperimente und Variieren von Test-Pulsen analysiert (Nussbaum Jennifer et al.:"Nonlinearity and thermal effects in gradient chains: a cascade analysis based on current and field sensing", PROCEEDINGS OF THE INTERNATIONAL SOCIETY FOR MAGNETIC RESONANCE IN MEDICINE, ISMRM, 27TH ANNUAL MEETING AND EXHIBITION, MONTREAL, QUEBEC, CANADA, 11 MAY - 16 MAY 2019, Nr. 213, 26. April 2019 [2019-04-26], XP040707600).

Die Druckschrift EP 3 543 722 A1 offenbart ein Magnetresonanzsystem mit einem Gradientenspulensystem und einem Stromsensorsystem, welches dazu ausgebildet ist, Stromsensordaten zu messen, welche elektrische Ströme beschreiben, die Gradientenspulen des Gradientenspulensystems zugeführt werden. Eine korrigierte k-Raum Trajektorie wird unter Verwendung der Stromsensordaten und einer Gradientenspulen-Transferfunktion berechnet und ein korrigiertes Magnetresonanzbild unter Verwendung von Magnetresonanzbilddaten und der korrigierten k-Raum Trajektorie rekonstruiert.

Rahmer et al. ermitteln genaue Felddynamiken durch Messung von ausgegebenen Gradientenverstärker-Strömen zeitgleich zu einer Bildgebung. Eine tatsächliche dynamische Feldentwicklung wird durch Faltung mit einer gemessenen Strom-zu-Feld Impulsantwort einer Gradientenspule bestimmt (Rahmer Jürgen et al.: "Non-Cartesian k-space trajectory calculation based on concurrent reading of the gradient amplifiers' output currents", MAGNETIC RESONANCE IN MEDICINE, Bd. 85, Nr. 6, 18. Februar 2021 [2021-02-18], Seiten 3060-3070, XP055873969, ISSN: 0740-3194, DOI: 10.1002/mrm.28725).

Goora et al. schlagen vor, eine zeitliche Entwicklung eines Magnetfeldgradienten direkt zu messen und eine Systemimpulsantwort zu extrahieren. Die Systemimpulsantwort wird zur Bestimmung von optimierten Eingangswellenformen verwendet, welche eine gewünschte Gradientenantwort an einem Ausgang des Systems erzeugen (Goora Frederic G et al.: "Arbitrary magnetic field gradient waveform correction using an impulse response based pre-equalization technique", JOURNAL OF MAGNETIC RESONANCE, ACADEMIC PRESS, ORLANDO, FL, US, Bd. 238, 15. November 2013 [2013-11-15], Seiten 70-76, XP028670722, ISSN: 1090-7807, DOI: 10.1016/J.JMR.2013.11.003).

Es ist eine Aufgabe der vorliegenden Erfindung, ein Verfahren zur Korrektur von Abweichungen zwischen ausgespielten Gradientenpulsen von erwarteten Gradientenverläufen während einer Magnetresonanzmessung bereitzustellen.

Diese Aufgabe wird durch die Gegenstände der unabhängigen Patentansprüche erfindungsgemäß gelöst. Vorteilhafte Ausführungsformen und zweckmäßige Weiterbildungen sind Gegenstand der Unteransprüche.

Das erfindungsgemäße Verfahren zur Korrektur einer Wirkung eines Störeffekts auf ein Gradientensystem einer Magnetresonanzvorrichtung bei einer Magnetresonanzmessung umfasst die folgenden Schritte:

- Aussenden eines Gradientenpulses $g_{ref}(t)$ mittels eines Verstärkers des Gradientensystems,
- Erfassen eines Gradientenverlaufs $g_{real}(t)$ welcher sich durch das Aussenden des Gradientenpulses $g_{ref}(t)$ in einem Untersuchungsbereich der Magnetresonanzvorrichtung einstellt, mittels einer Magnetfeldmessung in dem Untersuchungsbereich,
- Erfassen eines Ausgangssignals $i_{out}(t)$ des Verstärkers für den Gradientenpuls $g_{ref}(t)$,
- Ermitteln einer Gradientensystem-Übertragungsfunktion (GSTF, GIRF) in Abhängigkeit des erfassten Gradientenverlaufs $g_{real}(t)$ und des erfassten Ausgangssignals $i_{out}(t)$ des Verstärkers,
- Ermitteln eines Ausgangssignals $i_{cor}(t)$ des Verstärkers, bei welchem das Gradientensystem einen erwarteten Gradientenverlauf $g_{nom}(t)$ bereitstellt, in Abhängigkeit der ermittelten Gradientensystem-Übertragungsfunktion (GSTF, GIRF), und

Anpassen eines Eingangssignals $i_{in}(t)$ des Verstärkers in Abhängigkeit des ermittelten Ausgangssignals $i_{cor}(t)$ des Verstärkers und des erfassten Ausgangssignals $i_{out}(t)$ des Verstärkers.

In einem Schritt des erfindungsgemäßen Verfahrens wird zumindest ein Gradientenpuls $g_{ref}(t)$ ausgesendet. Der Gradientenpuls $g_{ref}(t)$ kann einen Teil einer Pulssequenz darstellen, welche einen oder mehrere Gradientenpulse, aber auch einen oder mehrere HF-Pulse, umfassen kann. Der Gradientenpuls kann beispielsweise einen regulären Gradientenpuls der Pulssequenz, welche für eine Durchführung einer Magnetresonanzmessung eines Untersuchungsobjekts benötigt wird, darstellen. Beispielsweise kann ein regulärer Gradientenpuls einen Bildgebungsgradienten oder einen Diffusionsgradienten umfassen. Ein Bildgebungsgradient dient vorzugsweise zu einer Lokalisierung einer Wirkung eines HF-Pulses. Der Gradientenpuls kann aber auch ausschließlich als ein Test-Gradientenpuls ausgesendet werden, insbesondere in Fällen, in denen übrige Gradientenpulse einer Pulssequenz als Test-Gradientenpuls ungeeignet sind. Weiterhin kann der Gradientenpuls eine Doppelfunktion als Test-Gradientenpuls und als regulärer Gradientenpuls in einer Pulssequenz einnehmen. Ein Test-Gradientenpuls kann insbesondere ein Gradientenpuls sein, welcher direkt oder indirekt zur Korrektur einer Wirkung eines Störeffekts auf das Gradientensystem der Magnetresonanzvorrichtung bei einer Magnetresonanzmessung verwendet wird. Störeffekte, wie das Auftreten von Wirbelströmen, Zeitabstimmungs- und Verstärkungsfehler, Feldfluktuationen, variable Temperatureinflüsse und/oder das nicht-linearen Verhalten von Hardware-Komponenten, wie **z. B.** dem Verstärker und/oder der Gradientenspule des Gradientensystems, können eine Abweichung zwischen ausgespielten Gradientenpulsen und erwarteten Gradientenverläufen verursachen.

Eine Magnetresonanzmessung stellt vorzugsweise eine bildgebende Untersuchung eines Untersuchungsobjekts, insbesondere eines Patienten, dar. Es ist vorstellbar, dass bei der Magnetresonanzmessung zweidimensionale, dreidimensionale und/der zeitabhängige dreidimensionale Bilddaten des Untersuchungsobjekts erfasst werden. Es ist jedoch ebenso vorstellbar, dass eine Magnetresonanzmessung für eine Kalibrierung und/oder einen Test der Magnetresonanzvorrichtung, aber auch eine Magnetresonanz-Spektroskopiemessung, durchgeführt wird. Hierbei kann das Untersuchungsobjekt beispielsweise ein Referenzobjekt, ein Phantom und/oder eine Feldprobe umfassen, welche in einer vorbestimmten Weise mit einer während der Magnetresonanzmessung ausgespielten Pulssequenz interagieren. In einer Ausführungsform umfasst die Durchführung der Magnetresonanzmessung das Ziel, Abweichungen zwischen ausgespielten Gradientenpulsen und erwarteten Gradientenverläufen mittels des erfindungsgemäßen Verfahrens zu charakterisieren.

Der ausgesandte Gradientenpuls $g_{ref}(t)$ weist vorzugsweise eine dreieckige Form, eine rechteckige Form oder eine Trapezform auf. Derart ausgebildete Gradientenpulse decken ein breites Frequenzspektrum ab und eignen sich daher besonders für eine Korrektur von Trajektorien im gesamten k-Raum. Es ist aber ebenso vorstellbar, dass der ausgesandte Gradientenpuls eine radiale oder eine spiralförmige Trajektorie aufweist.

Vorzugsweise ist ein erwarteter oder nomineller Gradientenverlauf $g_{nom}(t)$ mit dem ausgesandten Gradientenpuls $g_{ref}(t)$ assoziiert. Der erwartete Gradientenverlauf kann mit dem ausgesandten Gradientenpuls übereinstimmen, wenn keine Störeffekte in dem Gradientensystem auftreten. Der ausgesandte Gradientenpuls kann in diesem Fall ein "nomineller Gradientenpuls" sein, welcher durch nominelle Feldstärkewerte charakterisiert ist, die bei einem Aussenden eines Gradientenpulses zu erwarten sind. Bei einer realen Magnetresonanzmessung werden die nominellen Feldstärkewerte jedoch aufgrund von dynamischen Störeinflüssen von realen Feldstärkewerten des Gradientenpulses abweichen. Diese Abweichung kann durch eine entsprechende Messung des Gradientenverlaufs $g_{real}(t)$ ermittelt werden.

In einem Schritt wird der Gradientenverlauf $g_{real}(t)$ mittels einer Magnetfeldmessung in einem Untersuchungsbereich der Magnetresonanzvorrichtung erfasst. Bei dem erfassten Gradientenverlauf handelt es sich insbesondere um tatsächliche Feldstärkewerte, welche durch den ausgesandten Gradientenpuls $g_{ref}(t)$ in dem Untersuchungsbereich erzeugt werden. Das Erfassen des Gradientenverlaufs kann beispielsweise mittels eines Magnetometers oder einer Feldkamera erfolgen. Das Magnetometer bzw. die Feldkamera kann für das Erfassen des Gradientenverlaufs in den Untersuchungsbereich der Magnetresonanzvorrichtung eingeführt werden. Die Feldkamera kann hierfür eine Signalverbindung mit einer Eingangsschnittstelle der Magnetresonanzvorrichtung aufweisen und den erfassten Gradientenverlauf mittels der Signalverbindung an die Eingangsschnittstelle übertragen. Es ist weiterhin vorstellbar, dass der Gradientenverlauf von einer Hochfrequenz-Empfangsantenne der Magnetresonanzvorrichtung erfasst wird. Hierfür kann eine Feldprobe oder ein Volumen einer Referenzsubstanz, wie z. B. Wasser oder Öl, in den Untersuchungsbereich der Magnetresonanzvorrichtung eingebracht und mittels eines vorbestimmten HF-Pulses angeregt werden. Ein mittels einer Hochfrequenz-Empfangsantenne der Magnetresonanzvorrichtung empfangenes Magnetresonanzsignal der Feldprobe oder Referenzsubstanz kann anschließend analysiert werden, um eine Information über eine Eigenschaft des ausgesandten Gradientenpulses zu erhalten. Die Analyse des empfangenen Magnetresonanzsignals kann insbesondere einen Vergleich eines erwarteten Magnetresonanzsignals der Feldprobe oder Referenzsubstanz mit dem empfangenen Magnetresonanzsignal umfassen.

Unter einem Gradientenpuls kann eine Magnetfeldstärke oder ein zeitabhängiger Magnetfeldstärkeverlauf verstanden werden, welcher mittels des Gradientensystems bereitzustellen ist. Ein Gradientenverlauf kann dagegen durch eine messtechnisch erfasste Feldstärke oder einen erfassten, zeitabhängigen Feldstärkeverlauf charakterisiert sein. Der Gradientenverlauf ist somit insbesondere als ein tatsächlicher Magnetfeldgradient zu verstehen, welcher sich durch das Aussenden des Gradientenpulses in dem Untersuchungsbereich einstellt. Infolge einer Wirkung der oben genannten Störeffekte kann der Gradientenverlauf von dem Gradientenpuls abweichen.

In einem weiteren Schritt wird ein Ausgangssignal $i_{out}(t)$ des Verstärkers für den Gradientenpuls $g_{ref}(t)$ erfasst. Das Ausgangssignal $i_{out}(t)$ des Verstärkers kann insbesondere ein elektrischer Strom sein, welcher von dem Verstärker in eine Gradientenspule des Gradientensystems gespeist wird. Vorzugsweise erfolgt das Erfassen des Ausgangssignals des Verstärkers während der Gradientenpuls $g_{ref}(t)$ von einer Gradientenspule des Gradientensystems ausgesendet wird. Das Ausgangssignal des Verstärkers kann dabei mittels eines geeigneten Messgeräts, wie z. B. einer Stromzange, einer Rogowski-Spule, eines Spannungsmessgeräts, aber auch eines Mess- oder Stromwandlers, erfasst werden. Vorzugsweise wird das erfasste Ausgangssignal des Verstärkers an die Eingangsschnittstelle der Magnetresonanzvorrichtung übertragen. Es ist aber ebenso vorstellbar, dass das Ausgangssignal des Verstärkers in Abhängigkeit einer beliebigen Messgröße und/oder unter Zuhilfenahme einer bekannten Kennlinie oder Betriebscharakteristik des Verstärkers ermittelt wird. Unter dem Begriff Verstärker ist dabei insbesondere ein Gradientenverstärker zu verstehen, welcher ein Signal mit einem niedrigen Signalpegel (Eingangssignal des Verstärkers) auf ein Signal mit einem hohen Pegel (Ausgangssignal des Verstärkers) anhebt und/oder transformiert. Das Ausgangssignal des Verstärkers kann einer Gradientenspule des Gradientensystems zugeführt werden, welche entsprechend einen Magnetfeldgradienten in dem Untersuchungsbereich erzeugt (ausgesandter Gradientenpuls). In einer bevorzugten Ausführungsform weist das Gradientensystem zumindest drei Gradientenspulen auf, welche dazu ausgebildet sind, orthogonal zueinander ausgerichtete Magnetfeldgradienten bereitzustellen.

Bei einem Schritt des erfindungsgemäßen Verfahrens wird in Abhängigkeit des erfassten Gradientenverlaufs $g_{real}(t)$ und des erfassten Ausgangssignals $i_{out}(t)$ des Verstärkers eine Gradientensystem-Übertragungsfunktion (GSTF, GIRF) ermittelt. Das Ermitteln der Gradientensystem-Übertragungsfunktion kann dabei mittels einer Recheneinheit der Magnetresonanzvorrichtung erfolgen, welche eine Signalverbindung mit der Eingangsschnittstelle aufweist. Im Folgenden sollen die beiden Begriffe GSTF und GIRF zur Vereinfachung unter dem Begriff der Gradientensystem-Übertragungsfunktion subsummiert werden, da sich die beiden Funktionen mittels Gleichung (1) ineinander umwandeln lassen.

Die Gradientensystem-Übertragungsfunktion wird üblicherweise in Abhängigkeit des Quotienten eines mittels des Verstärkers ausgespielten Gradienten $G_{real}(f)$ und eines erwarteten bzw. nominellen Gradienten $G_{nom}(f)$ gemäß Gleichung (4) bestimmt. Diese Art von Gradientensystem-Übertragungsfunktion stellt eine sogenannten Gradienten-Eingangs-GSTF dar, bei welcher der nominelle Eingangsgradient $G_{nom}(f)$ für das Bestimmen der Gradientensystem-Übertragungsfunktion herangezogen wird.

$$GSTF = \frac{G_{real}(f)}{G_{nom}(f)} \qquad (4)$$

Dagegen wird die Gradientensystem-Übertragungsfunktion bei dem erfindungsgemäßen Verfahren in Abhängigkeit des erfassten Gradientenverlaufs $g_{real}(t)$ und des erfassten Ausgangssignals $i_{out}(t)$ des Verstärkers gemäß Gleichung (5) ermittelt. Hierfür können das erfasste Ausgangssignal $i_{out}(t)$ des Verstärkers und der erfasste Gradientenverlauf $g_{real}(t)$ mittels Fourier-Transformation zunächst in die Frequenz-Domäne ($I_{out}(f)$, $G_{re-al}(f)$) transformiert werden.

$$GSTF = \frac{G_{real}(f)}{I_{out}(f)} \qquad (5)$$

Vorzugsweise erfolgt das Ermitteln der Gradientensystem-Übertragungsfunktion GSTF unter Verwendung einer Mehrzahl von verschiedenen Gradientenpulsen, um ein breites Frequenzspektrum abzudecken. Das abgedeckte Frequenzspektrum kann dabei z. B. einen Frequenzbereich zwischen -20 kHz bis 20kHz, insbesondere zwischen -10 kHz bis 10 kHz, umfassen.

In einem weiteren Schritt des erfindungsgemäßen Verfahrens wird ein Ausgangssignal $i_{cor}(t)$ des Verstärkers, bei welchem das Gradientensystem einen erwarteten Gradientenverlauf ($g_{nom}(t)$) bereitstellt, in Abhängigkeit der ermittelten Gradientensystem-Übertragungsfunktion (GSTF, GIRF) ermittelt. Das Ermitteln des Ausgangssignals $i_{cor}(t)$ des Verstärkers erfolgt vorzugsweise mittels der Recheneinheit der Magnetresonanzvorrichtung. Die Recheneinheit weist vorzugsweise eine Signalverbindung mit der Eingangsschnittstelle auf. Wie oben beschrieben, kann die Eingangsschnittstelle dazu ausgebildet sein, den Gradientenverlauf sowie das Ausgangssignal des Verstärkers zu empfangen und mittels der Signalverbindung an die Recheneinheit zu übermitteln. Die Signalverbindung kann dabei kabellos oder kabelgebunden ausgestaltet sein.

Durch das erfindungsgemäße Verfahren lassen sich Störeffekte, wie z. B. eine nicht-lineare Betriebscharakteristik des Verstärkers und/oder ein variabler Temperatureinfluss auf das Gradientensystem, auf vorteilhafte Weise kompensieren. Ferner lassen sich Bildartefakte aufgrund solcher Störeffekten reduzieren oder vermeiden und eine Qualität von erfassten Bilddaten vorteilhaft erhöhen. Insbesondere wird durch die Ausgabe des Eingangssignals des Verstärkers eine direkte Anpassung des Verstärkers ermöglicht. Dadurch kann eine rechenintensive und/oder zeitintensive Korrektur von Störeffekten bei der Rekonstruktion von Bilddaten auf vorteilhafte Weise vermieden werden.

In einer bevorzugten Ausführungsform des erfindungsgemäßen Verfahrens erfolgen das Aussenden des Gradientenpulses $g_{ref}(t)$ und das Erfassen des Gradientenverlaufs $g_{real}(t)$ in einer wiederholenden Weise, insbesondere mit einer Häufigkeit zwischen eins bis fünf Repetitionsintervallen einer Pulssequenz der Magnetresonanzmessung.

Das Aussenden des Gradientenpulses und das Erfassen des Gradientenverlaufs erfolgen bevorzugt wiederholt in diskreten zeitlichen Abständen. Es ist vorstellbar, dass das wiederholte Aussenden des Gradientenpulses und das Erfassen des Gradientenverlaufs mit einer Häufigkeit oder Frequenz zwischen eins bis fünf Repetitionsintervallen der Pulssequenz der Magnetresonanzmessung erfolgen.

In einer Ausführungsform wird eine Häufigkeit des wiederholten Aussendens des Gradientenpulses und des Erfassens des Gradientenverlaufs während der Pulssequenz der Magnetresonanzmessung auf ein Mindestmaß reduziert. Experimente implizieren, dass relevante Temperaturänderungen bei der Magnetresonanzmessung nach etwa fünf Repetitionsintervallen auftreten können oder erst nach Ablauf einer Zeitdauer von fünf Repetitionsintervallen messtechnisch quantifizierbar sind. Durch eine Reduktion der Häufigkeit des wiederholten Aussendens des Gradientenpulses und des Erfassens des Gradientenverlaufs können eine Zeitdauer für die Magnetresonanzmessung und/oder ein Rechenaufwand für die Korrektur von Störeffekten vorteilhaft reduziert werden.

In einer bevorzugten Ausführungsform erfolgt das wiederholte Aussenden des Gradientenpulses und das Erfassen des Gradientenverlaufs in jedem Repetitionsintervall. Dadurch können auch unerwartet schnell auftretende Störeffekte, welche sich auf die Magnetfeldgradienten auswirken, auf vorteilhafte Weise zeitnah kompensiert werden. Ein Repetitionsintervall kann dabei als eine Zeitdauer verstanden werden, welche zwischen zwei aufeinanderfolgenden Anregungspulsen, insbesondere zwei aufeinanderfolgenden HF-Pulsen, vergeht.

In einer Ausführungsform umfasst das erfindungsgemäße Verfahren ferner den Schritt:

• Ermitteln einer Temperatur einer Gradientenspule des Gradientensystems,

wobei das Ermitteln des Ausgangssignals $i_{cor}(t)$ des Verstärkers in Abhängigkeit der Temperatur der Gradientenspule erfolgt.

Die Gradientenspule, von welcher die Temperatur ermittelt wird, stimmt dabei mit der Gradientenspule überein, welche in Abhängigkeit des Ausgangssignals $i_{out}(t)$ des Verstärkers den Gradientenpuls $g_{ref}(t)$ aussendet. Das Ermitteln der Temperatur einer Gradientenspule kann beispielsweise mittels eines Temperatursensors oder mehrerer Temperatursensoren erfolgen, welche an dem Gradientensystem, insbesondere an der Gradientenspule, positioniert sind. Vorzugsweise ist der Temperatursensor mechanisch mit der Gradientenspule verbunden und weist über die mechanische Verbindung eine thermische Kopplung mit der Gradientenspule auf. Der Temperatursensor kann dazu ausgebildet sein, einen Messwert für die Temperatur der Gradientenspule oder ein Signal, welches auf die Temperatur der Gradientenspule hinweist, mittels einer Signalverbindung an die Recheneinheit der Magnetresonanzvorrichtung zu übertragen. Die Recheneinheit kann entsprechend dazu ausgebildet sein, das Ausgangssignal des Verstärkers in Abhängigkeit der Temperatur der Gradientenspule zu ermitteln. Es ist ebenso vorstellbar, dass die Temperatur der Gradientenspule in Abhängigkeit eines Messwerts und/oder einer Betriebscharakteristik des Verstärkers ermittelt wird, welche sich von dem Temperaturmesswert unterscheiden.

Gemäß einer weiteren Ausführungsform weist das erfindungsgemäße Verfahren ferner den Schritt auf:

• Ermitteln eines Widerstands und/oder einer Induktivität der Gradientenspule,

wobei das Ermitteln der Temperatur der Gradientenspule in Abhängigkeit des Widerstands und/oder der Induktivität der Gradientenspule erfolgt.

Vorzugsweise wird die Temperatur der Gradientenspule in Abhängigkeit eines Widerstands und/oder einer Induktivität der Gradientenspule oder der Gradientenspulen ermittelt. Daneben können selbstverständlich auch weitere Messwerte für das Ermitteln der Temperatur der Gradientenspule herangezogen werden. Bevorzugt wird die Temperatur der Gradientenspule in Abhängigkeit eines Messwiderstands (Shunt-Widerstand), welcher an ein Spannungsmessgerät angeschlossen ist, ermittelt. Es ist aber ebenso vorstellbar, dass die Temperatur der Gradientenspule in Abhängigkeit einer temperaturabhängigen Eigenschaft, wie **z. B.** einer Länge eines Referenzdrahts, aber auch einer Induktivität der Gradientenspule, ermittelt wird.

In einer weiteren Ausführungsform des erfindungsgemäßen Verfahrens erfolgt das Ermitteln der Temperatur der Gradientenspule in Abhängigkeit eines Modells und/oder eines intelligenten Algorithmus.

Ein intelligenter Algorithmus kann eine beliebige Anwendung von künstlicher Intelligenz umfassen. Eine künstliche Intelligenz kann **z. B.** einen selbstlernenden Algorithmus, ein neuronales Netz, ein mehrschichtiges neuronales Netz, ein Expertensystem oder dergleichen umfassen, welche in Abhängigkeit eines Messwerts oder mehrerer Messwerte des Gradientensystems die Temperatur der Gradientenspule ermitteln. Es ist ferner vorstellbar, dass der intelligente Algorithmus die Temperatur der Gradientenspule in Abhängigkeit einer bekannten Betriebscharakteristik des Verstärkers und/oder der Gradientenspule ermittelt. Der intelligente Algorithmus kann weiterhin ein Modell der Gradientenspule und/oder des Verstärkers heranziehen, um die Temperatur der Gradientenspule zu ermitteln.

Weiterhin kann die Temperatur der Gradientenspule in Abhängigkeit eines Modells bestimmt werden. Ein Modell kann insbesondere ein Simulationsmodell, ein analytisches Modell, ein empirisches Modell und/oder ein modelbasierter Ansatz sein, welche den Verstärker und/oder die Gradientenspule beschreiben oder modellieren.

In einer bevorzugten Ausführungsform erfolgt das Ermitteln der Temperatur der Gradientenspule in Abhängigkeit des erfassten Ausgangssignals $i_{out}(t)$ des Verstärkers.

Bei Kenntnis des Stroms, welcher von dem Verstärker in die Gradientenspule gespeist wird, lässt sich die Temperatur in Abhängigkeit physikalischer Grundzusammenhänge und/oder analytischer Modelle der Gradientenspule sehr genau bestimmen. Vorzugsweise erfolgt das Ermitteln der Temperatur der Gradientenspule bei Verwendung eines Modells und/oder eines intelligenten Algorithmus mittels der Recheneinheit des Magnetresonanzsystems. Selbstverständlich kann das Ermitteln der Temperatur der Gradientenspule auch ein Ermitteln von Temperaturen mehrerer Gradientenspulen umfassen, welche bei einer Pulssequenz verwendet werden.

Durch das Ermitteln der Temperatur der Gradientenspule lässt sich das Ausgangssignal des Verstärkers auf vorteilhafte Weise mit einer erhöhten Genauigkeit ermitteln. Ferner kann das Ausgangssignal des Verstärkers in Abhängigkeit der Temperatur der Gradientenspule auf eine besonders robuste und/oder reproduzierbare Weise ermittelt werden, da variable Temperatureinflüsse auf die Gradientenspule berücksichtigt werden können.

Weiterhin weist das erfindungsgemäße Verfahren den Schritt auf:

- Anpassen eines Eingangssignals $i_{in}(t)$ des Verstärkers in Abhängigkeit des ermittelten Ausgangssignals $i_{cor}(t)$ des Verstärkers und des erfassten Ausgangssignals $i_{out}(t)$ des Verstärkers.

Es ist vorstellbar, dass das Anpassen des Eingangssignals des Verstärkers in Abhängigkeit einer geeigneten Regeleinrichtung erfolgt. Eine solche Regeleinrichtung kann beispielsweise dazu ausgebildet sein, das Eingangssignal des Verstärkers in Abhängigkeit des ermittelten Ausgangssignal des Verstärkers und des erfassten Ausgangssignal des Verstärkers anzupassen. Die Regeleinrichtung kann insbesondere dazu ausgebildet sein, das Eingangssignal des Verstärkers in Abhängigkeit einer Differenz zwischen dem ermittelten Ausgangssignal des Verstärkers und dem erfassten Ausgangssignal des Verstärkers anzupassen.

Vorzugsweise erfolgt das Anpassen des Eingangssignals des Verstärkers kontinuierlich oder in diskreten Zeitschritten. Beispielsweise erfolgt das Anpassen des Eingangssignals des Verstärkers mehrfach pro Repetitionsintervall, ein Mal pro Repetitionsintervall, jedes zweite Repetitionsintervall, jedes dritte Repetitionsintervall oder jedes vierte oder fünfte Repetitionsintervall. Das Anpassen des Eingangssignals des Verstärkers kann insbesondere nach jedem Aussenden eines Gradientenpulses $g_{ref}(t)$ und/oder Erfassen eines Gradientenverlaufs $g_{real}(t)$ erfolgen.

Es ist weiterhin vorstellbar, dass das Anpassen des Eingangssignals des Verstärkers in einem zweiten Repetitionsintervall in Abhängigkeit eines in einem ersten Repetitionsintervall ermittelten Ausgangssignals des Verstärkers bzw. in Abhängigkeit einer in dem ersten Repetitionsintervall ermittelten Gradientensystem-Übertragungsfunktion erfolgt. Das erste Repetitionsintervall und das zweite Repetitionsintervall können dabei auch mehrere Repetitionsintervalle voneinander beabstandet sein. Diese Vorgehensweise wird auch als "Pre-Emphasis" bezeichnet. Bei diesem Vorgehen kann eine Korrektur bereits beim Aussenden des Gradientenpulses in dem zweiten Repetitionsintervall vorgenommen werden, sodass die Bildrekonstruktion keiner Korrekturen der Gradientenfelder mehr bedarf.

Durch ein erfindungsgemäßes Anpassen des Eingangssignals des Verstärkers lassen sich Störeffekte in dem Gradientensystem auf vorteilhafte Weise zeitnah und/oder automatisch korrigieren.

Gemäß einer weiteren Ausführungsform des erfindungsgemäßen Verfahrens erfolgt das Anpassen des Eingangssignals $i_{in}(t)$ des Verstärkers mittels eines adaptiven Filters, insbesondere eines Volterra-Filters, eines Spline-Filters und/oder eines Kernel-Filters, erfolgt.

Vorzugsweise lässt sich das Eingangssignal des Verstärkers mittels Verwendung eines nicht-linearen, adaptiven Filters adaptiv anpassen, sodass Störeffekte in dem Gradientensystem mittels Veränderung des Eingangssignals des Verstärkers kompensiert werden. Hierbei kann das an einem Eingang des Verstärkers anliegende Eingangssignal das adaptive Filter durchlaufen und eine sogenannten Ausgangsfolge bilden. Diese Ausgangsfolge kann mit einer von dem adaptiven Filter zu bildenden Folge, wie dem ermittelten Ausgangssignal $i_{cor}(t)$ des Verstärkers, verglichen werden, um ein Fehlersignal zu ermitteln. Bei einer Abweichung der Ausgangsfolge von der zu bildenden Folge kann ein Regelalgorithmus des adaptiven Filters eine Veränderung von Filterkoeffizienten vornehmen, um das Fehlersignal zu minimieren und die Ausgangsfolge des adaptiven Filters an die zu bildende Folge anzupassen. Hierbei können bekannte Methoden zur Minimierung der Fehlerquadrate, wie z. B. dem Least-Mean-Squares-Algorithmus (LMS) oder dem Recursive-Least-Squares-Algorithmus (RLS), verwendet werden.

Vorzugsweise umfasst das adaptive Filter eine Volterra-LMS Methode, bei welcher diskrete Eingangswerte durch verschiedene, nicht-lineare algebraische Ausdrücke, sogenannte Volterra-Serien, ersetzt werden.

Das Anpassen des Eingangssignals des Verstärkers kann beispielsweise auf direkte oder indirekte Weise in Abhängigkeit einer Ausgangsfolge des adaptiven Filters erfolgen. In einer Ausführungsform wird die Ausgangsfolge des adaptiven Filters als ein Steuersignal mittels einer Signalverbindung an den Verstärker und/oder eine Steuereinheit des Verstärkers oder der Magnetresonanzvorrichtung übertragen. Die Ausgangsfolge kann dabei insbesondere das Eingangssignal des Verstärkers darstellen. Es ist aber ebenso vorstellbar, dass die Ausgangsfolge ein Korrektursignal darstellt, in deren Abhängigkeit das Eingangssignal des Verstärkers angepasst wird.

Das adaptive Filter kann zum Beispiel als ein analoges Filter oder ein digitales Filter implementiert sein. In einer bevorzugten Ausführungsform ist das adaptive Filter als ein Teil eines DSP (digital signal processor), eines FPGA (field programmable gate array) und/oder eines FPAA (field programmable analog array) implementiert.

Mittels Verwendung eines adaptiven Filters lassen sich auch komplexe und/oder nicht-lineare Störeffekte des Gradientensystems auf vorteilhafte Weise kompensieren.

Bei einer weiteren Ausführungsform des erfindungsgemäßen Verfahrens umfasst das Aussenden des Gradientenpulses $g_{test}(t)$ ein Aussenden einer Mehrzahl von Gradientenpulsen $g_{test,i}(t)$, wobei die Mehrzahl von Gradientenpulsen ($g_{test,i}(t)$) ein Frequenzspektrum zwischen -20 kHz bis +20 kHz, insbesondere -10 kHz bis +10 kHz, abdeckt.

Vorzugsweise umfasst auch das Erfassen des Gradientenverlaufs $g_{real}(t)$ ein Erfassen eines Gradientenverlaufs für jeden Gradientenpuls der Mehrzahl von Gradientenpulsen. Dabei kann für jeden Gradientenverlauf auch ein Ausgangssignal $i_{out}(t)$ des Verstärkers erfasst werden. Es ist vorstellbar, dass auf diese Weise eine Gradientensystem-Übertragungsfunktion für eine Mehrzahl von Gradientenpulsen und eine Mehrzahl von Verstärker-Ausgangsströmen ermittelt wird. Die Gradientensystem-Übertragungsfunktion kann dabei durch eine Überlagerung bzw. eine Superposition der Mehrzahl von erfassten Gradientenverläufen und erfassten Verstärker-Ausgangsströmen charakterisiert sein.

Durch das Ermitteln der Gradientensystem-Übertragungsfunktion für eine Mehrzahl von Gradientenpulsen, welche ein breites Frequenzspektrum abdecken, lassen sich auf vorteilhafte Weise Störeffekte des Gradientensystems bei beliebigen Gradientenpulsen, welche von dem Frequenzspektrum umfasst sind, korrigieren oder kompensieren.

Die erfindungsgemäße Korrektureinrichtung weist eine Ausgangsschnittstelle auf, welche dazu ausgebildet ist, zumindest einen Gradientenpuls $g_{ref}(t)$ auszusenden. Die Ausgangsschnittstelle kann z. B. einen Ausgangskanal eines Verstärkers eines Gradientensystems des Magnetresonanzsystems umfassen.

Die erfindungsgemäße Korrektureinrichtung umfasst weiterhin eine Eingangsschnittstelle, welche dazu ausgebildet ist, einen mittels einer Magnetfeldmessung in einem Untersuchungsbereich einer Magnetresonanzvorrichtung erfassten Gradientenverlauf $g_{real}(t)$, welcher sich durch ein Aussenden des Gradientenpulses $g_{ref}(t)$ in dem Untersuchungsbereich einstellt, sowie ein Ausgangssignal $i_{out}(t)$ eines Verstärkers für den Gradientenpuls $g_{ref}(t)$ zu empfangen. Vorzugsweise weist die Eingangsschnittstelle hierfür eine Signalverbindung mit einer Feldkamera, einem Magnetometer oder einer Hochfrequenz-Empfangsantenne auf. Die Eingangsschnittstelle kann ebenso als ein Teil der Hochfrequenz-Empfangsantenne ausgebildet sein. Es ist weiterhin vorstellbar, dass die Eingangsschnittstelle eine Signalverbindung mit einem Stromsensor, einem Spannungssensor und/oder einem Temperatursensor aufweist. Grundsätzlich kann die Eingangsschnittstelle eine Signalverbindung mit einem beliebigen Sensor aufweisen, welcher dazu ausgebildet ist, eine Eigenschaft des Gradientensystems gemäß einer oben beschriebenen Ausführungsform messtechnisch zu erfassen. Zudem weist die erfindungsgemäße Korrektureinrichtung eine Recheneinheit auf, welche dazu ausgebildet ist, eine Gradientensystem-Übertragungsfunktion (GSTF, GIRF) in Abhängigkeit des erfassten Gradientenverlaufs $g_{real}(t)$ und des erfassten Ausgangssignals $i_{out}(t)$ des Verstärkers zu ermitteln. Die Recheneinheit ist ferner dazu ausgebildet, ein Ausgangssignal $i_{cor}(t)$ des Verstärkers in Abhängigkeit der Gradientensystem-Übertragungsfunktion zu ermitteln.

Die erfindungsgemäße Korrektureinrichtung ist weiterhin dazu ausgebildet, ein Eingangssignal $i_{in}(t)$ des Verstärkers in Abhängigkeit des ermittelten Ausgangssignals $i_{cor}(t)$ des Verstärkers und des erfassten Ausgangssignals $i_{out}(t)$ des Verstärkers anzupassen. Das Ermitteln der Gradientensystem-Übertragungsfunktion GSTF, des Ausgangssignals $i_{cor}(t)$ des Verstärkers, aber auch das Anpassen des Eingangssignals $i_{in}(t)$ des Verstärkers, können dabei gemäß einer oben beschriebenen Ausführungsform des erfindungsgemäßen Verfahrens mittels der Korrektureinrichtung erfolgen.

Die erfindungsgemäße Korrektureinrichtung teilt die Vorteile des erfindungsgemäßen Verfahrens zur Korrektur einer Wirkung eines Störeffekts auf ein Gradientensystem einer Magnetresonanzvorrichtung bei einer Magnetresonanzmessung.

Die erfindungsgemäße Magnetresonanzvorrichtung umfasst eine Korrektureinrichtung gemäß einer oben beschriebenen Ausführungsform, wobei die Magnetresonanzvorrichtung dazu ausgebildet ist, ein Eingangssignal $i_{in}(t)$ eines Verstärkers während einer Magnetresonanzmessung eines Untersuchungsobjekts mittels der Korrektureinrichtung anzupassen, um einen erwarteten Gradientenverlauf $g_{nom}(t)$ bereitzustellen.

Insbesondere kann die erfindungsgemäße Magnetresonanzvorrichtung dazu ausgebildet sein, einen Ablauf einzelner Verfahrensschritte eines erfindungsgemäßen Verfahrens gemäß einer oben beschriebenen Ausführungsform autark zu koordinieren und durchzuführen. Auf diese Weise lässt sich das Anpassen des Eingangssignals des Verstärkers in Abhängigkeit einer Gradientensystem-Übertragungsfunktion und eines ermittelten Ausgangssignals des Verstärkers auf vorteilhafte Weise reproduzierbar und/oder automatisch durchführen.

Das erfindungsgemäße Magnetresonanzsystem umfasst ein Grundfeldmagnetsystem, eine Hochfrequenz-Sendeantenne, ein Gradientensystem, eine Hochfrequenz-Empfangsantenne und eine Korrektureinrichtung gemäß einer oben beschriebenen Ausführungsform sowie eine Steuereinheit zur Ansteuerung des Grundfeldmagnetsystems, der Hochfrequenz-Sendeantenne, des Gradientsystems und der Hochfrequenz-Empfangsantenne.

Durch die Bereitstellung des erfindungsgemäßen Magnetresonanzsystems können die Komponenten des erfindungsgemäßen Magnetresonanzsystems, wie z. B. das Grundfeldmagnetsystem, die Hochfrequenz-Sendeantenne, das Gradientensystem, die Hochfrequenz-Empfangsantenne sowie die Korrektureinrichtung und die Steuereinheit, vorteilhaft aufeinander abgestimmt sein, sodass eine zeiteffiziente und/oder robuste Durchführung eines erfindungsgemäßen Verfahrens gemäß einer oben beschriebenen Ausführungsform ermöglicht wird.

Das erfindungsgemäße Computerprogrammprodukt mit einem Computerprogramm, welches direkt in eine Speichereinheit der Steuereinheit eines erfindungsgemäßen Magnetresonanzsystems ladbar ist, mit Programmabschnitten, um alle Schritte eines erfindungsgemäßen Verfahrens gemäß einer oben beschriebenen Ausführungsform auszuführen, wenn das Computerprogramm mittels der Steuereinheit des Magnetresonanzsystems ausgeführt wird.

Die erfindungsgemäße Korrektureinrichtung kann bevorzugt in Form von Software auf einer geeigneten programmierbaren Steuereinheit eines Magnetresonanzsystems mit einer entsprechenden Speichereinheit realisiert sein. Auch eine Hochfrequenz-Sendeeinheit, eine Ausgangsschnittstelle und eine Hochfrequenz-Empfangseinheit können zumindest teilweise in Form von Softwareeinheiten realisiert sein, wobei wiederum andere Einheiten dieser Komponenten reine Hardwareeinheiten sein können. Solche Hardwareeinheiten können beispielsweise ein Hochfrequenzverstärker, eine Antenneneinrichtung der Hochfrequenz-Sendeeinheit und/oder der Hochfrequenz-Empfangseinheit, eine Gradientenpuls-Erzeugungseinrichtung der Ausgangsschnittstelle, ein Analog-/Digitalwandler der Hochfrequenz-Empfangseinheit und dergleichen sein.

Eine weitgehend softwaremäßige Realisierung, insbesondere der genannten Komponenten, hat den Vorteil, dass auch schon bisher verwendete Steuereinheiten eines Magnetresonanzsystems auf einfache Weise durch ein Software-Update nachgerüstet werden können, um auf die erfindungsgemäße Weise zu arbeiten. Insofern wird die Aufgabe auch durch ein Computerprogrammprodukt gelöst, welches in einer transportablen Speichereinheit hinterlegt und/oder über ein Netzwerk zur Übertragung bereitgestellt wird und so direkt in einen Speicher einer programmierbaren Steuereinheit des Magnetresonanzsystems ladbar ist, mit Programmabschnitten, um alle Schritte des erfindungsgemäßen Verfahrens gemäß einer oben beschriebenen Ausführungsform auszuführen, wenn das Programm mittels der Steuereinheit ausgeführt wird. Ein solches Computerprogrammprodukt kann neben dem Computer-programm gegebenenfalls zusätzliche Bestandteile wie z. B. eine Dokumentation und/oder zusätzliche Komponenten, auch Hardware-Komponenten, wie z. B. Hardware-Schlüssel (Dongles etc.) zur Nutzung der Software, umfassen.

Auf dem erfindungsgemäßen computerlesbaren Medium sind von einer Recheneinheit einlesbare und ausführbare Programmabschnitte gespeichert, um alle Schritte eines erfindungsgemä-ßen Verfahrens gemäß einer oben beschriebenen Ausführungsform auszuführen, wenn die Programmabschnitte von der Recheneinheit ausgeführt werden.

Für einen Transport von Teilen der Steuereinheit und/oder zur Speicherung an oder in der Steuereinheit kann ein computerlesbares Medium, beispielsweise ein Memorystick, eine Festplatte oder ein sonstiger transportabler oder fest eingebauter Datenträger dienen, auf welchem die von einer Recheneinheit der Steuereinheit einlesbaren und ausführbaren Programmabschnitte des Computerprogramms gespeichert sind. Die Recheneinheit kann hierfür beispielsweise einen oder mehrere zusammenarbeitende Mikroprozessoren oder dergleichen aufweisen.

Weitere Vorteile und Einzelheiten der vorliegenden Erfindung ergeben sich aus den im Folgenden beschriebenen Ausführungsbeispielen sowie anhand der Zeichnungen. Dabei zeigen:

Fig. 1    eine Ausführungsform eines erfindungsgemäßen Magnetresonanzsystems,

Fig. 2    eine schematische Darstellung einer Wirkung von Störeffekten bei einer Magnetresonanzmessung,

Fig. 3    ein Diagramm, welches einen variablen Temperatureinfluss auf ein Gradientensystem eines Magnetresonanzsystems veranschaulicht,

Fig. 4    eine schematische Darstellung eines Prinzips einer Anpassung eines Eingangssignals eines Verstärkers mittels einer erfindungsgemäßen Korrektureinrichtung,

Fig. 5    ein Schaubild, welches eine Ermittlung einer Gradientensystem-Übertragungsfunktion in Abhängigkeit einer Mehrzahl von Gradientenpulsen veranschaulicht,

Fig. 6    ein Ablaufdiagramm einer möglichen Ausführungsform eines erfindungsgemäßen Verfahrens.

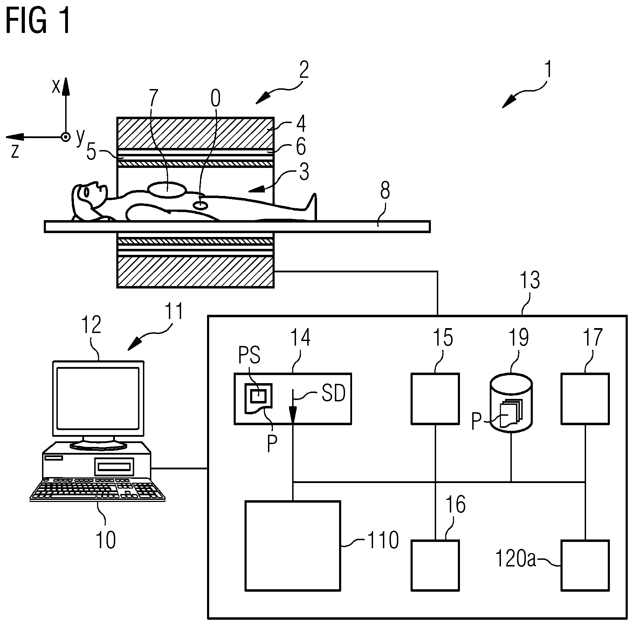

Bei dem in Fig. 1 gezeigten Magnetresonanzsystem 1 handelt es sich um eine Magnetresonanzvorrichtung 2 mit einem als Patiententunnel ausgestalteten Untersuchungsbereich 3, in den ein Untersuchungsobjekt vollständig eingebracht werden kann. Das Untersuchungsobjekt ist im vorliegenden Beispiel ein Patient, welcher mittels der Patientenlagerungsvorrichtung 8 relativ zu der Magnetresonanzvorrichtung 2 positioniert werden kann. Grundsätzlich kann das erfindungsgemäße Magnetresonanzsystem 1 aber auch eine andere Magnetresonanzvorrichtung, z. B. mit seitlich offenem, C-förmigen Gehäuse, umfassen. Wesentlich ist, dass die Magnetresonanzvorrichtung 2 dazu ausgebildet ist, Magnetresonanzmessungen durchzuführen, um Bilddaten des Untersuchungsobjekts erfassen zu können.

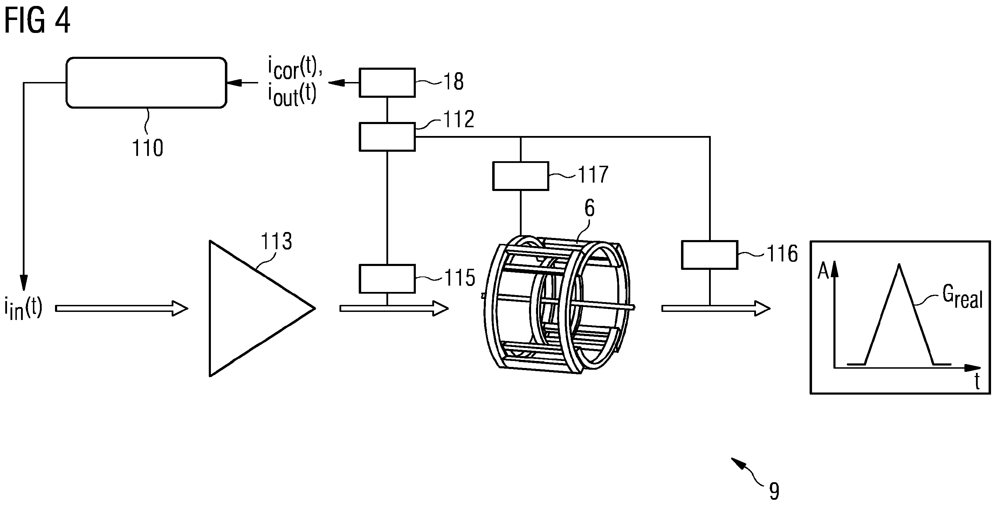

Die Magnetresonanzvorrichtung 2 ist in bevorzugt mit einem Grundfeldmagnetsystem 4, zumindest einer Gradientenspule 6 sowie einer Hochfrequenz-Sendeantenne 5 und einer Hochfrequenz-Empfangsantenne 7 ausgestattet. In dem dargestellten Ausführungsbeispiel handelt es sich bei der Hochfrequenz-Sendeantenne 5 um eine in der Magnetresonanzvorrichtung 2 fest eingebauten Körperspule. Dagegen handelt es sich bei der Hochfrequenz-Empfangsantenne 7 um eine oder mehrere an dem Patienten angeordnete Lokalspulen. Grundsätzlich können aber auch die Körperspule als Hochfrequenz-Empfangsantenne und die Lokalspulen als Hochfrequenz-Sendeantenne ausgestaltet sein und/oder eine entsprechende Funktionalität aufweisen. Das Grundfeldmagnetsystem 4 ist vorliegend dazu ausgebildet, ein Grundmagnetfeld in Längsrichtung des Patienten zu erzeugen, d. h. entlang der in Z-Richtung verlaufenden Längsachse der Magnetresonanzvorrichtung 2. Vorzugsweise umfasst das Gradientensystem 9 (siehe Fig. 4) der Magnetresonanzvorrichtung 2 eine Mehrzahl einzeln ansteuerbarer Gradientenspulen 6, um unabhängig voneinander Gradienten in X-, Y- oder Z-Richtung ausspielen zu können.

Das Magnetresonanzsystem 1 weist eine zentrale Steuereinheit 13 auf, welche zur Steuerung des Magnetresonanzsystems 1 verwendet wird. Diese zentrale Steuereinheit 13 kann auch eine Sequenzsteuereinheit 14 umfassen. Mit der Sequenzsteuereinheit 14 wird die Abfolge von HF-Pulsen und von Gradientenpulsen in Abhängigkeit von einer gewählten Pulssequenz PS oder einer Abfolge von mehreren Pulssequenzen PS zum Erfassen von Bilddaten eines relevanten Volumens des Untersuchungsobjekts, insbesondere einer oder mehrerer Schichten des interessierenden Volumenbereichs, im Rahmen einer Magnetresonanzmessung gesteuert. Eine solche Pulssequenz PS kann beispielsweise innerhalb eines Mess- oder Steuerprotokolls P vorgegeben und parametrisiert sein. Üblicherweise sind verschiedene Steuerprotokolle P für unterschiedliche Magnetresonanzmessungen in einer Speichereinheit 19 hinterlegt und können von einem Bediener ausgewählt, bei Bedarf geändert, und dann zur Durchführung der Magnetresonanzmessung genutzt werden. Im vorliegenden Fall enthält die Steuereinheit 13 mehrere Pulssequenzen PS zur Akquisition von Rohdaten.

Zur Ausgabe einzelner HF-Pulse einer Pulssequenz PS weist die zentrale Steuereinheit 13 eine Sendeeinheit 15 auf. Die Sendeeinheit 15 erzeugt und verstärkt die HF-Pulse und übermittelt sie über eine Signalverbindung sowie eine geeignete Schnittstelle an die Hochfrequenz-Sendeantenne 5 (nicht im Detail dargestellt). Zur Steuerung der Gradientenspulen 6 des Gradientensystems 9, insbesondere um entsprechend einer vorgegebenen Pulssequenz PS die Gradientenpulse passend zu schalten oder auszuspielen, weist die Steuereinheit 13 eine Ausgangsschnittstelle 16 auf. Mittels der Ausgangsschnittstelle 16 können beispielsweise Diffusions-Gradientenpulse oder Spoiler-Gradientenpulse appliziert werden. Die Ausgangsschnittstelle 16 weist vorliegend eine Signalverbindung mit einer Gradientenspule 6 (siehe Fig. 4) des Gradientensystems 9 auf, welche in Abhängigkeit der applizierten Gradientenpulse entsprechende Magnetfeldgradienten in dem Untersuchungsbereich 3 erzeugt. Die Sequenzsteuereinheit 14 kommuniziert in geeigneter Weise, z. B. durch Aussendung von Sequenzsteuerdaten SD, mit der Sendeeinheit 15 und der Ausgangsschnittstelle 16 zur Durchführung der Pulssequenz PS.

Die Steuereinheit 13 weist außerdem eine (ebenfalls in geeigneter Weise mit der Sequenzsteuereinheit 14 kommunizierende) Hochfrequenz-Empfangseinheit 17 auf, um innerhalb eines durch die Pulssequenz PS vorgegebenen Auslesefensters mittels der Hochfrequenz-Empfangsantenne 7 koordiniert Magnetresonanzsignale zu empfangen und so die Rohdaten zu akquirieren.

Das Magnetresonanzsystem 1 kann ferner eine Rekonstruktionseinheit 120a aufweisen, welche dazu ausgebildet ist, Bilddaten des Untersuchungsobjekts in Abhängigkeit von erfassten Magnetresonanzsignalen zu rekonstruieren. Diese Rekonstruktion kann auf Basis von Parametern erfolgen, welche in dem jeweiligen Mess- oder Steuerprotokoll P vorgegeben sein können. Die rekonstruierten Bilddaten können dann beispielsweise in der Speichereinheit 19 hinterlegt werden.

Die Korrektureinrichtung 110 weist mit den anderen Komponenten, insbesondere der Ausgangsschnittstelle 16 und/oder der Sequenzsteuereinheit 14, eine Signalverbindung auf. Alternativ kann die Korrektureinrichtung 110 auch als ein Teil der Sequenzsteuereinheit 14 ausgestaltet sein. Die Korrektureinrichtung 110 ist vorzugsweise dazu ausgebildet, geeignete Gradientenpulse $g_{ref}(t)$ zu generieren und an die Ausgangsschnittstelle 16 bzw. die Gradientenspule 6 zu übermitteln. Es ist vorstellbar, dass die Korrektureinrichtung 110 hierfür einen Verstärker 113 (siehe Fig. 4) des Gradientensystems 9 umfasst und ein Eingangssignal $i_{in}(t)$ des Verstärkers 113 vorgibt. Alternativ kann die Korrektureinrichtung 110 auch getrennt von dem Verstärker 113 vorliegen und ein Aussenden von Gradientenpulsen $g_{ref}(t)$ mittels einer geeigneten Signalverbindung initiieren. Die Korrektureinrichtung 110 ist insbesondere dazu ausgebildet, ein Eingangssignal $i_{in}(t)$ des Verstärkers 113 in Abhängigkeit eines ermittelten Ausgangssignals $i_{cor}(t)$ und eines erfassten Ausgangssignals $i_{out}(t)$ des Verstärkers 113 anzupassen (siehe Fig. 4).

Eine Bedienung der zentralen Steuereinheit 13 kann über ein Terminal 11 mit einer Eingabeeinheit 10 und einer Anzeigeeinheit 12 erfolgen. Vorzugsweise lässt sich das Magnetresonanzsystem 1 von einem Bediener mittels des Terminals 11 steuern. Die Anzeigeeinheit 12 kann dazu ausgebildet sein, erfasste Bilddaten einer Magnetresonanzmessung auszugeben. Die Eingabeeinheit 10 kann dazu ausgebildet sein, gegebenenfalls in Kombination mit der Anzeigeeinheit 12, Magnetresonanzmessungen mittels des Magnetresonanzsystems 1 zu parametrieren und zu starten. Dies kann insbesondere eine Auswahl und/oder Modifikation von Steuerprotokollen P und/oder Pulssequenzen PS umfassen.

Das erfindungsgemäße Magnetresonanzsystem 1 und insbesondere die Steuereinheit 13 können darüber hinaus noch eine Vielzahl von weiteren, hier nicht im Einzelnen dargestellten, aber üblicherweise an derartigen Anlagen vorhandenen Komponenten aufweisen, wie beispielsweise eine Netzwerkschnittstelle, um das gesamte System mit einem Netzwerk zu verbinden und Rohdaten und/oder Bilddaten bzw. Parameterkarten, aber auch weitere Daten, wie beispielsweise patientenrelevante Daten oder Steuerprotokolle, austauschen und/oder bearbeiten zu können.

Wie im Detail durch ein Einstrahlen von HF-Pulsen und das Aussenden von Gradientenpulsen geeignete Magnetresonanzsignale erfasst und daraus Bilddaten oder Parameter-Karten rekonstruiert werden können, ist dem Fachmann grundsätzlich bekannt. Ebenso sind verschiedenste Messsequenzen, wie z. B. EPI-Messsequenzen oder andere Messsequenzen zur Erzeugung von Bilddaten, auch diffusionsgewichteten Bilddaten, dem Fachmann vom Grundsatz her bekannt. Auf diese Aspekte soll daher im Folgenden nicht genauer eingegangen werden.

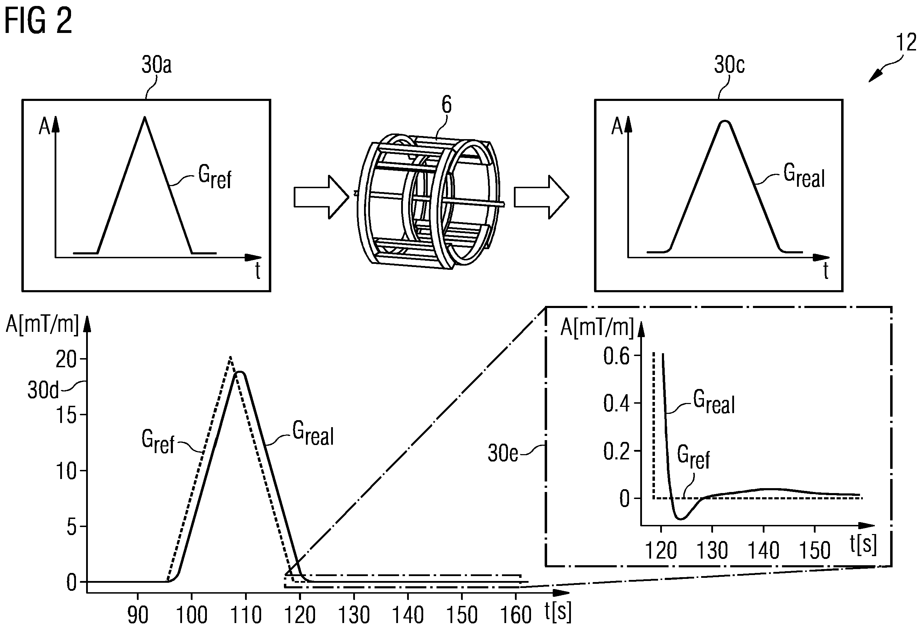

In Fig. 2 ist eine vergleichende Darstellung 30 von ausgesandten Gradienten $G_{ref}$ und den tatsächlich ausge-spielten Gradienten $G_{real}$ einer Pulssequenz einer Magnetresonanzmessung gezeigt. Die ausgesandten Gradienten $G_{ref}$ weisen Feldstärkewerte auf, welche mittels der Steuereinheit 13 des Magnetresonanzsystems 1 festgelegt werden. Dagegen entsprechen die realen Gradienten $G_{real}$ den in einem Untersuchungsbereich tatsächlich gemessenen Feldstärkewerten. In einer Teildarstellung 30a ist ein Schaubild eines Eingabe-Gradienten bzw. ausgesandten Gradienten $G_{ref}$ gezeigt, welcher von der Steuereinheit 13 der Magnetresonanzvorrichtung 2 erzeugt wird und an die Gradientenspule 6 der Magnetresonanzvorrichtung 2 des Magnetresonanzsystems 1 übermittelt wird. Der von der Gradientenspule 6 tatsächlich ausgespielte Gradient $G_{real}$ wird in einem Teilschaubild 30c gezeigt. Der ausgesandte Gradient $G_{ref}$ weist in dem in Fig. 2 gezeigten Beispiel eine Dreiecksform auf. Eine solche Dreiecksform deckt einen relativ breiten Frequenzbereich ab und kann daher ein Antwortverhalten eines Gradienten im Frequenzraum relativ gut abbilden. Der tatsächlich ausgespielte Gradient $G_{real}$ weist aufgrund der bereits der oben beschriebenen Störeffekte des Gradientensystems 9, wie zum Beispiel einem nicht-linearen Verhalten eines Verstärkers 113 (siehe Fig. 4), thermische Veränderungen der Hardwarekomponenten, aber auch Wirbelströme und/oder zeitliche Abstimmungs- und Verstärkerfehler, eine von dem ausgesandten Gradienten $G_{ref}$ abweichende Gradientenform auf.

In einem Teilschaubild 30d sind beide Gradienten $G_{ref}$ und $G_{real}$ gemeinsam dargestellt. Wie in dem Teilschaubild 30e zu erkennen ist, kann der reale Gradient $G_{real}$ in Relation zu dem ausgesandten Gradienten $G_{ref}$ auch einen Zeitversatz aufweisen.

Ein Ausschnitt des Teilschaubilds 30d wird in einem Teilschaubild 30e vergrößert dargestellt. In dem Teilschaubild 30e ist zu erkennen, dass der tatsächliche Gradient $G_{real}$ bzw. eine Amplitude A des tatsächlichen Gradienten $G_{real}$ bei t = 122 s unter den ausgesandten Gradienten $G_{nom}$ abfällt und bei etwa t = 130 s einen höheren Magnitudenwert als der ausgesandte Gradient $G_{ref}$ annimmt, um bei Werten von t = 160 s wieder mit dem ausgesandten Gradienten auf der Nulllinie zusammenzufallen.

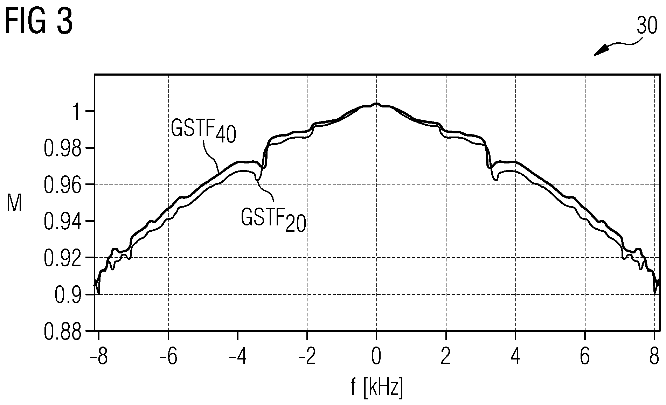

In Fig. 3 ist ein Schaubild 30 gezeigt, welches Magnituden M zweier Gradientensystem-Übertragungsfunktion GSTF bei verschiedenen Referenztemperaturen darstellt. Die Gradientensystem-Übertragungsfunktion GSTF wird vorliegend anhand des Quotienten aus dem realen Gradienten $G_{real}$ und dem erfassten Ausgangssignal $I_{out}$ des Verstärkers 113 ermittelt. In Fig. 3 sind zwei Gradientensystem-Übertragungsfunktionen $GSTF_{20}$, $GSTF_{40}$ für zwei verschiedene, mittlere Temperaturen des Gradientensystems 9 von 20°C und 40°C veranschaulicht. Die Magnituden M der $GSTF_{20}$, $GSTF_{40}$ über die Frequenz f sind dabei in kHz aufgetragen. Wie in dem Schaubild 30 zu erkennen ist, ist die Magnitude M der Gradientensystem-Übertragungsfunktion bei 40°C etwas höher als bei 20°C.

Fig. 4 zeigt ein eine schematische Darstellung eines Ablaufs des Anpassens des Eingangssignals $i_{in}(t)$ des Verstärkers 113 in Abhängigkeit des ermittelten Ausgangssignals $i_{cor}(t)$ und des erfassten Ausgangssignals $i_{out}(t)$ des Verstärkers 113. Vorzugsweise weist das Gradientensystem 9 des Magnetresonanzsystems 1 einen Sensor 115 auf, welcher dazu ausgebildet ist, ein Signal zu erfassen, welches mit dem Ausgangssignal $i_{out}(t)$ des Verstärkers 113 korreliert ist. Der Sensor 115 kann ferner dazu ausgebildet sein, das Signal mittels einer Signalverbindung an eine Recheneinheit 18 des Magnetresonanzsystems 1 zu übermitteln.

Das Magnetresonanzsystem 1 weist ferner eine Feldkamera 116 auf, welche dazu ausgebildet ist, den Gradientenverlauf $g_{real}(t)$ des ausgesandten Gradientenpulses $g_{ref}(t)$ zu erfassen und mittels einer Signalverbindung an die Recheneinheit 18 zu übermitteln.

Die Recheneinheit 18 ist entsprechend dazu ausgebildet, die Gradientensystem-Übertragungsfunktion GSTF in Abhängigkeit des realen Gradientenverlaufs $g_{real}(t)$ und des erfassten Ausgangssignals $i_{out}(t)$ des Verstärkers 113 zu ermitteln. Die Recheneinheit 18 ist vorliegenden ebenso dazu ausgebildet, das Ausgangssignal $i_{cor}(t)$ des Verstärkers 113, bei welchem das Gradientensystem 9 den erwarteten Gradientenverlauf $g_{ref}(t)$ bereitstellt, in Abhängigkeit der Gradientensystem-Übertragungsfunktion GSTF zu ermitteln. Das Ausgangssignal $i_{cor}(t)$ des Verstärkers 113 stellt somit insbesondere ein Zielwert eines Ausgangssignals des Verstärkers 113 dar, bei welchem auftretende Störeffekte des Gradientensystems 9 korrigiert oder kompensiert werden.

In dem vorliegenden Beispiel übermittelt die Recheneinheit 18 das Ausgangssignal $i_{cor}(t)$ des Verstärkers 113 sowie das erfasste Ausgangssignal $i_{out}(t)$ des Verstärkers 113 an die Korrektureinrichtung 110. Es ist ebenso vorstellbar, dass die Recheneinheit 18 in die Korrektureinrichtung 110 integriert ist. Die Korrektureinrichtung 110 ist dazu ausgebildet, das Eingangssignal $i_{in}(t)$ des Verstärkers 113 in Abhängigkeit des Ausgangssignals $i_{cor}(t)$ des Verstärkers 113 und des erfassten Ausgangssignals $i_{out}(t)$ des Verstärkers 113 anzupassen. Hierfür kann die Korrektureinrichtung 110 zum Beispiel eine Regeleinrichtung, insbesondere ein adaptives Filter, gemäß einer oben beschriebenen Ausführungsform aufweisen.

In dem gezeigten Beispiel stimmt der erfasste Verlauf des Gradienten $G_{real}(f)$ mit dem ausgesandten bzw. nominellen Gradient $G_{ref}(f)$ (wie in Fig. 2 gezeigt) im Wesentlichen überein, da die Korrektureinrichtung 110 die Störeffekte in dem Gradientensystem 9 mittels Anpassens des Eingangssignals $i_{in}(t)$ des Verstärkers 113 korrigiert. Der Verlauf des ausgespielte Gradienten $G_{ref}(f)$ stimmt somit im Wesentlichen mit dem erwarteten bzw. nomineller Gradienten $G_{nom}(f)$ überein.

In einer Ausführungsform wird die Temperatur der Gradientenspule 6 mittels eines Temperatursensors 117 erfasst, welcher an der Gradientenspule 6 positioniert ist. Es ist vorstellbar, dass die Temperatur der Gradientenspule 6 an die Eingangsschnittstelle 112 übermittelt und von der Recheneinheit 18 bei dem Ermitteln des Ausgangssignals $i_{cor}(t)$ des Verstärkers 113 herangezogen wird.

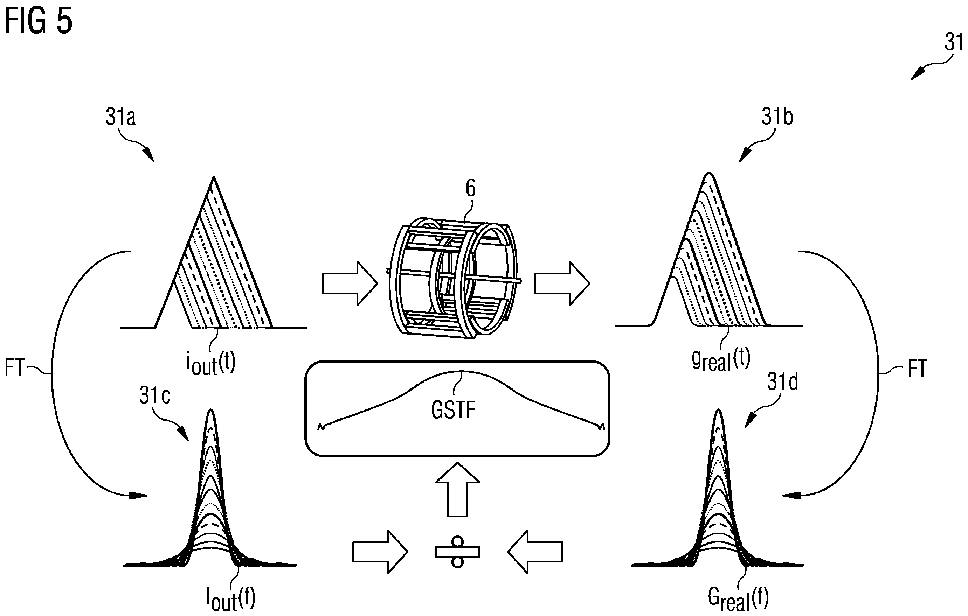

In Fig. 5 ist ein Schaubild 31 gezeigt, welches das Prinzip des Ermittelns einer Gradientensystem-Übertragungsfunktion GSTF unter Anwendung einer Kombination von zwölf unterschiedlichen dreiecksförmig ausgebildeten Gradientenpulsen $g_{ref,i}(t)$ darstellt. Die Gradientenpulse $g_{ref,i}(t)$ weisen jeweils ein von dem Verstärker 113 ausgegebenes Ausgangssignal $i_{out,i}(t)$ auf, welches mittels der Ausgangsschnittstelle 16 an die Gradientenspule 6 übermittelt wird. In dem Teilschaubild 31a ist ein Ensemble von zwölf dreiecksförmig ausgebildeten Ausgangssignalen $i_{out,i}(t)$ des Verstärkers 113 mit unterschiedlichen Linienmustern (gestrichelt, durchgezogen, gepunktet) gezeigt. Diese erzeugen beim Passieren der Gradientenspule 6 des Gradientensystems 9 der Magnetresonanzvorrichtung 2 tatsächliche Gradientenverläufe $g_{real,i}(t)$, welche in dem Teilschaubild 31b gezeigt sind. Wie in dem Teilschaubild 31b zu erkennen ist, weichen die realen Gradientenpulse $g_{real,i}(t)$ infolge von Störeffekten von erwarteten Gradientenverläufen $g_{nom,i}(t)$ ab, welche im Wesentlichen mit den ausgesandten Gradientenpulsen $g_{ref,i}(t)$ übereinstimmen (siehe auch Fig. 2). Die beiden Teilschaubilder 31a und 31b sind in der Zeitdomäne dargestellt. Dagegen zeigen die Teilschaubilder 31c und 31d die Ausgangssignale $I_{out,i}(f)$ des Verstärkers 113 sowie die realen Gradienten $G_{real,i}(f)$ in Frequenzbereich. Die Ausgangssignale $I_{out,i}(f)$ des Verstärkers 113 und die realen Gradienten $G_{real,i}(f)$ ergeben sich jeweils durch eine Fouriertransformation FT von $i_{out,i}(t)$ und $g_{real,i}(t)$ aus der Zeitdomäne in die Frequenzdomäne. Das Schaubild 31 zeigt weiterhin eine Gradientensystem-Übertragungsfunktion GSTF, welche durch Division der realen Gradienten $G_{real,i}(f)$ durch die Eingangssignale $I_{out,i}(f)$ des Verstärkers 113 ermittelt wird. Dieser Sachverhalt ist in Fig. 5 durch ein Divisionszeichen "÷" symbolisiert.

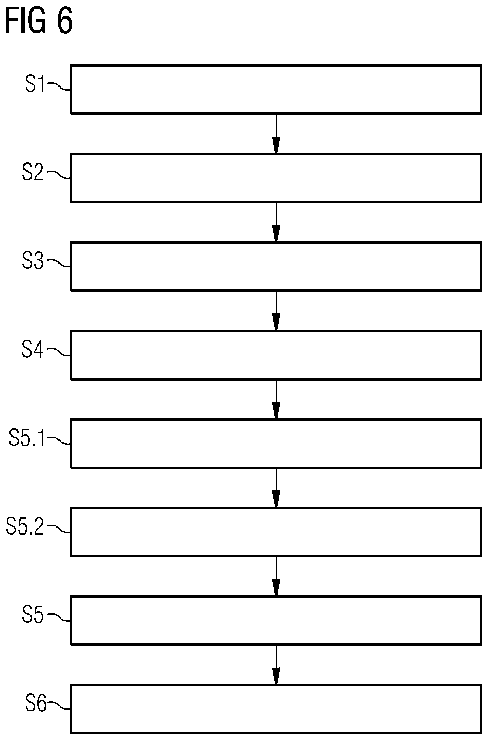

Fig. 6 zeigt ein Ablaufdiagramm einer Ausführungsform eines erfindungsgemäßen Verfahrens zur Korrektur einer Wirkung eines Störeffekts auf ein Gradientensystem 9 einer Magnetresonanzvorrichtung 2 bei einer Magnetresonanzmessung.

In einem Schritt S1 des erfindungsgemäßen Verfahrens wird ein Gradientenpuls $g_{ref}(t)$ mittels des Verstärkers 113 ausgesendet. Der Gradientenpuls kann insbesondere ein Test-Gradientenpuls oder ein regulärer Gradientenpuls während einer Magnetresonanzmessung eines Patienten darstellen. Der Gradientenpuls wird von der Ausgangsschnittstelle 16 des Verstärkers 113 des Gradientensystems 9 bereitgestellt und an eine Gradientenspule 6 des Gradientensystems 9 übermittelt, welche den Gradientenpuls in Form eines Magnetfeldgradienten in dem Untersuchungsbereich 3 bereitstellt.

In einer Ausführungsform des erfindungsgemäßen Verfahrens erfolgt das Aussenden des Gradientenpulses $g_{ref}(t)$ und das Erfassen des Gradientenverlaufs $g_{real}(t)$ in einer wiederholenden Weise, insbesondere mit einer Frequenz zwischen eins bis fünf Repetitionsintervallen der Magnetresonanzmessung.

In einem Schritt S2 wird ein Gradientenverlauf $g_{real}(t)$ mittels einer Magnetfeldmessung in einem Untersuchungsbereich 3 der Magnetresonanzvorrichtung 2 erfasst. Das Erfassen des Gradientenverlaufs kann dabei insbesondere mittels eines Magnetometers bzw. einer Feldkamera 116 erfolgen, welche Informationen und/oder erfasste Magnetfelddaten bezüglich des Gradientenverlaufs an die Eingangsschnittstelle 112 der Magnetresonanzvorrichtung 2, insbesondere der Korrektureinrichtung 110, überträgt. Das Magnetometer bzw. die Feldkamera 116 kann hierfür mittels einer kabelgebundenen oder einer kabellosen Signalverbindung mit der Eingangsschnittstelle 112 verbunden sein.

In einem weiteren Schritt S3 wird ein Ausgangssignal $i_{out}(t)$ des Verstärkers 113 für den Gradientenpuls $g_{ref}(t)$ erfasst. Vorzugsweise wird das Ausgangssignal des Verstärkers 113 mittels eines geeigneten Sensors 115, wie z. B. einer Stromzange, einer Rogowski-Spule, eines Spannungsmessgeräts, aber auch eines Mess- oder Stromwandlers, erfasst werden. Der Sensor 115 kann insbesondere eine Signalverbindung mit der Eingangsschnittstelle 112 aufweisen, um eine Information und/oder einen Messwert bezüglich des Ausgangssignals des Verstärkers 113 an die Steuereinheit 13 und/oder die Recheneinheit 18 zu übermitteln.

In einem Schritt S4 wird eine Gradientensystem-Übertragungsfunktion (GSTF, GIRF) in Abhängigkeit des erfassten Gradientenverlaufs $g_{real}(t)$ und des gemessenen Ausgangssignals $i_{out}(t)$ des Verstärkers 113 ermittelt. Vorzugsweise erfolgt das Ermitteln der Gradientensystem-Übertragungsfunktion gemäß Gleichung (5) sowie des oben beschriebenen Vorgehens (siehe Fig. 4).

In einem weiteren Schritt S5 erfolgt ein Ermitteln eines Ausgangssignals $i_{cor}(t)$ des Verstärkers 113, bei welchem das Gradientensystem einen erwarteten Gradientenverlauf $g_{nom}(t)$ bereitstellt, in Abhängigkeit der ermittelten Gradientensystem-Übertragungsfunktion (GSTF, GIRF). Hierfür wird das Ausgangssignal $i_{cor}(t)$ des Verstärkers 113 vorzugsweise anhand von Gleichung (6) bestimmt.

$$i_{cor}(t) = \mathcal{F}^{-1}\{G_{nom}(f) \cdot GSTF^{-1}(f)\} \qquad (6)$$

Das Ausgangssignal $i_{cor}(t)$ des Verstärkers 113 stellt dabei ein Ausgangssignal dar, welches benötigt wird, um den erwarteten, nominellen Gradientenpuls $g_{nom}(t)$ in dem Untersuchungsbereich 3 der Magnetresonanzvorrichtung 2 bereitzustellen. Der nominelle Gradientenpuls $g_{nom}(t)$ kann dabei im Wesentlichen mit dem Gradientenverlauf $g_{real}(t)$ übereinstimmen, solange keine Störeffekte im Gradientensystem 9 auftreten oder auftretende Störeffekte mittels der Korrektureinrichtung 110 durch Anpassen des Eingangssignals $i_{in}(t)$ des Verstärkers 113 korrigiert werden. Der Term $GSTF^{-1}$ stellt dabei die Inverse der GSTF dar, welche in Abhängigkeit des erfassten Gradientenverlaufs $g_{real}(t)$ und des erfassten Ausgangssignals $i_{out}(t)$ des Verstärkers 113 gemäß Gleichung (5) ermittelt wird.

Gemäß einer Ausführungsform erfolgt das Ermitteln des Ausgangssignals $i_{cor}(t)$ des Verstärkers 113 in Abhängigkeit einer Temperatur einer Gradientenspule 6. Hierfür kann die Temperatur der Gradientenspule 6 in die Gleichung (7) für das nominelle Ausgangssignal $i_{cor}(t)$ des Verstärkers 113 integriert werden. Vorzugsweise wird hierbei ein Ausdruck für die temperaturabhängige Gradientensystem-Übertragungsfunktion $GSTF_T$ verwendet.

$$i_{cor}^T(t) = \mathcal{F}^{-1}\{G_{nom}(f) \cdot GSTF_T^{-1}(f)\} \qquad (7)$$

Die Temperaturabhängigkeit der Gradientensystem-Übertragungsfunktion $GSTF_T$ kann zum Beispiel mittels eines linearen Modells für eine temperaturabhängige Änderung der Gradientensystem-Übertragungsfunktion $\Delta GSTF$ gemäß Gleichung (8) ermittelt werden. Hierbei können $T_{meas}$ eine Matrix von gemessenen Temperaturwerten zu verschiedenen Zeitpunkten $T_{t=0}$ bis $T_{t=N}$ und $m$ ein Modelparameter darstellen. Dieser Ansatz kann eine heuristische Modellierung umfassen, bei welcher die Modellparameter $m$ kalibriert werden.

$$\Delta GSTF = T_{meas} \cdot m \qquad (8)$$

Es ist aber ebenso vorstellbar, dass die Temperaturabhängigkeit der Gradientensystem-Übertragungsfunktion $GSTF_T$ in Abhängigkeit einer Änderung des Widerstands $\Delta R$ der Gradientenspule 6 ermittelt wird. Durch die Änderung des Widerstands der Gradientenspulen 6 bei unterschiedlichen Temperaturen kann die temperaturabhängige Änderung der Gradientensystem-Übertragungsfunktion $\Delta GSTF$ mittels des Folgenden Zusammenhangs (9) bestimmt werden:

$$\Delta GSTF = f(\Delta R(T)) \qquad (9)$$

In einem optionalen Schritt S5.1 wird eine Temperatur einer Gradientenspule 6 des Gradientensystems 9 ermittelt. Vorzugsweise wird dabei die Temperatur einer oder mehrerer Gradientenspulen 6 des Gradientensystems 9 mittels einer oder mehrerer Temperatursensoren erfasst und mittels einer Signalverbindung an die Steuereinheit 13 und/oder die Recheneinheit 18 des Magnetresonanzsystems 1 übermittelt. Die Recheneinheit 18 ist entsprechend dazu ausgebildet, das Ausgangssignal $i_{cor}(t)$ des Verstärkers 113 in Abhängigkeit der Temperatur der Gradientenspule 6 mittels der Gleichung (7) zu bestimmen.

In einer Ausführungsform erfolgt das Ermitteln der Temperatur der Gradientenspule 6 in Abhängigkeit eines Modells und/oder eines intelligenten Algorithmus. Es ist vorstellbar, dass das Ermitteln der Temperatur der Gradientenspule 6 in Abhängigkeit einer bekannten Betriebscharakteristik des Verstärkers 113 erfolgt. Weiterhin können ein analytisches Modell, ein empirisches Modell und/oder ein Simulationsmodell des Verstärkers 113, aber auch der Gradientenspule 6, für das Ermitteln der Temperatur der Gradientenspule 6 herangezogen werden. Ferner können Informationen über einen mechanischen und/oder elektrischen Aufbau des Verstärkers 113 und/oder der Gradientenspule 6, eine Anordnung und/oder elektrische Verbindung von elektronischen Komponenten und/oder eine thermische Leitfähigkeit sowie eine Wärmekapazität von verwendeten Materialien, bei dem Ermitteln der Temperatur der Gradientenspule 6 verwendet werden.

In einer alternativen Ausführungsform erfolgt das Ermitteln der Temperatur der Gradientenspule 6 in Abhän-

gigkeit des erfassten Ausgangssignals $i_{out}(t)$ des Verstärkers 113. Bei Kenntnis eines Stroms, welcher von dem Verstärker 113 in die Gradientenspule 6 gespeist wird, lässt sich die Temperatur der Gradientenspule 6 in Abhängigkeit eines einfachen analytischen Modells der Gradientenspule 6 sehr genau bestimmen. Vorzugsweise erfolgt das Ermitteln der Temperatur der Gradientenspule 6 bei Verwendung eines Modells und/oder eines intelligenten Algorithmus mittels der Recheneinheit 18 des Magnetresonanzsystems 1.

In einem optionalen Schritt S5.2 wird ein Widerstand und/oder eine Induktivität der Gradientenspule 6 des Gradientensystems 9 ermittelt. Das Ermitteln des Widerstands und/oder der Induktivität kann insbesondere gemäß einer oben beschriebenen Ausführungsform des erfindungsgemäßen Verfahrens erfolgen. In einem Beispiel wird die Temperatur der Gradientenspule 6 in Abhängigkeit eines Messwiderstands (Shunt-Widerstand) ermittelt, welcher an ein Spannungsmessgerät angeschlossen ist. Der Widerstand und/oder die Induktivität der Gradientenspule 6 können anschließend für ein Ermitteln der Temperatur der Gradientenspule 6 in dem Schritt S5.1 herangezogen werden.

In einem optionalen Schritt S6 erfolgt ein Anpassen eines Eingangssignals $i_{in}(t)$ des Verstärkers 113 in Abhängigkeit des ermittelten Ausgangssignals $i_{cor}(t)$ des Verstärkers 113 und des erfassten Ausgangssignals $i_{out}(t)$ des Verstärkers 113. Das Anpassen des Eingangssignals des Verstärkers kann auf direkte oder indirekte Weise mittels einer geeigneten Regeleinrichtung, insbesondere mittels eines adaptiven Filters, erfolgen. Für das Anpassen des Eingangssignals des Verstärkers wird vorzugsweise eine Korrektureinrichtung 110 verwendet (siehe Fig. 4). Diese kann ein gemäß Gleichung (6) oder Gleichung (7) ermitteltes Ausgangssignal $i_{cor}(t)$ des Verstärkers 113 von der Recheneinheit 18 des Magnetresonanzsystems 1 empfangen und in quasi-kontinuierlicher Weise oder in diskreten Zeitschritten mit dem mittels der Eingangsschnittstelle 112 erfassten Ausgangssignal $i_{out}(t)$ des Verstärkers 113 vergleichen. Bei Vorliegen einer Abweichung zwischen dem ermittelten Ausgangssignal $i_{cor}(t)$ und dem erfassten Ausgangssignal $i_{out}(t)$ des Verstärkers 113 wird das Eingangssignal $i_{-in}(t)$ des Verstärkers 113 mittels der Korrektureinrichtung 110 so angepasst, dass die Abweichung reduziert wird. Somit können Störeffekte in dem Gradientensystem 6 bereits beim Aussenden eines Gradientenpulses mittels der Korrektureinrichtung 110 korrigiert werden.

In einer Ausführungsform erfolgt das Anpassen des Eingangssignals $i_{in}(t)$ des Verstärkers 113 mittels eines adaptiven Filters, insbesondere eines Volterra-Filters, eines Spline-Filters und/oder eines Kernel-Filters. Vorzugsweise umfasst das adaptive Filter eine Volterra-LMS Methode, bei welcher für eine Minimierung von Fehlerquadraten ein Least-Mean-Square-Algorithmus (LMS) verwendet wird.

Es wird darauf hingewiesen, dass es sich bei den zuvor detailliert beschriebenen Verfahren und Aufbauten lediglich um Ausführungsbeispiele handelt und dass das Grundprinzip auch in weiten Bereichen vom Fachmann variiert werden kann, ohne den Bereich der Erfindung zu verlassen, soweit er durch die Ansprüche vorgegeben ist. Weiterhin ist das beschriebene Verfahren auch nicht auf medizinische Anwendungen beschränkt. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können.

**Patentansprüche**

1. Verfahren zur Korrektur einer Wirkung eines Störeffekts auf ein Gradientensystem (9) einer Magnetresonanzvorrichtung (2) bei einer Magnetresonanzmessung, aufweisend die Schritte:

   • Aussenden (S1) eines Gradientenpulses ($g_{ref}(t)$) mittels eines Verstärkers (113) des Gradientensystems (9),
   • Erfassen (S2) eines Gradientenverlaufs ($g_{real}(t)$), welcher sich durch das Aussenden des Gradientenpulses ($g_{ref}(t)$) in einem Untersuchungsbereich (3) der Magnetresonanzvorrichtung (2) einstellt, mittels einer Magnetfeldmessung in dem Untersuchungsbereich (3),
   • Erfassen (S3) eines Ausgangssignals ($i_{out}(t)$) des Verstärkers (113) für den Gradientenpuls ($g_{ref}(t)$),
   • Ermitteln (S4) einer Gradientensystem-Übertragungsfunktion (GSTF, GIRF) in Abhängigkeit des erfassten Gradientenverlaufs ($g_{real}(t)$) und des erfassten Ausgangssignals ($i_{out}(t)$) des Verstärkers (113), **gekennzeichnet durch** die Schritte
   • Ermitteln (S5) eines Ausgangssignals ($i_{cor}(t)$) des Verstärkers (113), bei welchem das Gradientensystem (9) einen erwarteten Gradientenverlauf ($g_{nom}(t)$) bereitstellt, in Abhängigkeit der ermittelten Gradientensystem-Übertragungsfunktion (GSTF, GIRF) und
   • Anpassen (S6) eines Eingangssignals ($i_{in}(t)$) des Verstärkers (113) in Abhängigkeit des ermittelten Ausgangssignals ($i_{cor}(t)$) des Verstärkers (113) und des erfassten Ausgangssignals ($i_{out}(t)$) des Verstärkers (113).

2. Verfahren nach Anspruch 1, wobei das Aussenden (S1) des Gradientenpulses ($g_{ref}(t)$) und das Erfassen (S2) des Gradientenverlaufs ($g_{real}(t)$) in einer wiederholenden Weise, insbesondere mit einer Häufigkeit zwischen eins bis fünf Repetitionsintervallen einer Pulssequenz (PS) der Magnetresonanzmessung, erfolgen.

3. Verfahren nach Anspruch 1 oder 2, ferner aufweisend den Schritt:

   • Ermitteln (S5.1) einer Temperatur einer Gradientenspule (6) des Gradientensystems (9),

   wobei das Ermitteln (S5) des Ausgangssignals $i_{cor}(t)$ des Verstärkers (113) in Abhängigkeit der Temperatur der Gradientenspule (6) erfolgt.

4. Verfahren nach Anspruch 3, ferner aufweisend den Schritt:

   • Ermitteln (S5.2) eines Widerstands und/oder einer Induktivität der Gradientenspule (6) des Gradientensystems (9),

   wobei das Ermitteln (S5.1) der Temperatur der Gradientenspule (6) in Abhängigkeit des Widerstands und/oder der Induktivität der Gradientenspule (6) erfolgt.

5. Verfahren nach einem der Ansprüche 3 oder 4, wobei das Ermitteln (S5.1) der Temperatur der Gradientenspule (6) in Abhängigkeit eines Modells und/oder eines intelligenten Algorithmus erfolgt.

6. Verfahren nach einem der Ansprüche 3 bis 5, wobei das Ermitteln (S5.1) der Temperatur der Gradientenspule (6) in Abhängigkeit des erfassten Ausgangssignals ($i_{out}(t)$) des Verstärkers (113) erfolgt.

7. Verfahren nach einem der vorhergehenden Ansprüche, wobei das Anpassen (S6) des Eingangssignals ($i_{in}(t)$) des Verstärkers (113) mittels eines adaptiven Filters, insbesondere eines Volterra-Filters, eines Spline-Filters und/oder eines Kernel-Filters, erfolgt.

8. Verfahren nach einem der vorhergehenden Ansprüche, wobei das Aussenden (S1) des Gradientenpulses ($g_{ref}(t)$) ein Aussenden einer Mehrzahl von Gradientenpulsen ($g_{ref,i}(t)$) umfasst, und wobei die Mehrzahl von Gradientenpulsen ($g_{test,i}(t)$) ein Frequenzspektrum zwischen -20 kHz bis +20 kHz, insbesondere -10 kHz bis +10 kHz, abdeckt.

9. Korrektureinrichtung (110), aufweisend:

   • eine Ausgangsschnittstelle (16), welche dazu ausgebildet ist, zumindest einen Gradientenpuls ($g_{ref}(t)$) auszusenden,
   • eine Eingangsschnittstelle (112), welche dazu ausgebildet ist, einen mittels einer Magnetfeldmessung in einem Untersuchungsbereich (3) einer Magnetresonanzvorrichtung (2) erfassten Gradientenverlauf ($g_{real}(t)$), welcher sich durch ein Aussenden des Gradientenpulses ($g_{ref}(t)$) in dem Untersuchungsbereich (3) einstellt, sowie ein Ausgangssignal ($i_{out}(t)$) eines Verstärkers (113) für den Gradientenpuls ($g_{ref}(t)$) zu erfassen, **gekennzeichnet durch**
   • eine Recheneinheit (18), welche dazu ausgebildet ist, eine Gradientensystem-Übertragungsfunktion (GSTF, GIRF) und ein Ausgangssignal ($i_{cor}(t)$) des Verstärkers (113) in Abhängigkeit des erfassten Gradientenverlaufs ($g_{real}(t)$) und des erfassten Ausgangssignals ($i_{out}(t)$) des Verstärkers (113) zu ermitteln,

   wobei die Korrektureinrichtung (110) dazu ausgebildet ist, ein Eingangssignal ($i_{in}(t)$) des Verstärkers (113) in Abhängigkeit des ermittelten Ausgangssignals ($i_{cor}(t)$) des Verstärkers (113) und des erfassten Ausgangssignals ($i_{out}(t)$) des Verstärkers (113) anzupassen.

10. Magnetresonanzsystem (1), umfassend ein Grundfeldmagnetsystem (4), eine Hochfrequenz-Sendeantenne (5), ein Gradientensystem (9), eine Hochfrequenz-Empfangsantenne (7) und eine Korrektureinrichtung (110) nach Anspruch 9 sowie eine Steuereinheit (13) zur Ansteuerung des Grundfeldmagnetsystems (4), der Hochfrequenz-Sendeantenne (5), des Gradientensystems (9) und der Hochfrequenz-Empfangsantenne (7), wobei das Magnetresonanzsystem (1) dazu ausgebildet ist, ein Eingangssignal ($i_{in}(t)$) eines Verstärkers (113) während einer Magnetresonanzmessung eines Untersuchungsobjekts mittels der Korrektureinrichtung (110) anzupassen, um einen erwarteten Gradientenverlauf ($g_{nom}(t)$) bereitzustellen.

11. Computerprogrammprodukt mit einem Computerprogramm, welches direkt in eine Speichereinheit (19) der Steuereinheit (13) eines Magnetresonanzsystem (1) nach Anspruch 10 ladbar ist, mit Programmabschnitten, um alle Schritte eines Verfahrens nach einem der Ansprüche 1 bis 8 auszuführen, wenn das Computerprogramm mittels der Steuereinheit (13) des Magnetresonanzsystems (1) ausgeführt wird.

12. Computerlesbares Medium, auf welchem von einer Recheneinheit (18) einlesbare und ausführbare Programmabschnitte gespeichert sind, um alle Schritte eines Verfahrens nach einem der Ansprüche 1 bis 8 auszuführen, wenn die Programmabschnitte von der Recheneinheit (18) ausgeführt werden.

**Claims**

1. Method for correcting an influence of an interference effect on a gradient system (9) of a magnetic resonance apparatus (2) during a magnetic resonance scan, having the steps:

   • emitting (S1) a gradient pulse ($g_{ref}(t)$) by means of an amplifier (113) of the gradient system (9),
   • capturing (S2) a gradient sequence ($g_{real}(t)$) which becomes established in an examination region (3) of the magnetic resonance apparatus (2) by way of the emission of the gradient pulse ($g_{ref}(t)$), by means of a magnetic field measurement in the examination region (3),
   • capturing (S3) an output signal ($i_{out}(t)$) of the amplifier (113) for the gradient pulse ($g_{ref}(t)$),
   • establishing (S4) a gradient system transfer function (GSTF, GIRF) dependent upon the captured gradient sequence ($g_{real}(t)$) and the captured output signal ($i_{out}(t)$) of the amplifier (113), **characterised by** the steps
   • establishing (S5) an output signal ($i_{cor}(t)$) of the amplifier (113) with which the gradient system (9) provides an expected gradient sequence ($g_{nom}(t)$), dependent upon the established gradient system transfer function (GSTF, GIRF) and
   • adjusting (S6) an input signal ($i_{in}(t)$) of the amplifier (113) dependent upon the established output signal ($i_{cor}(t)$) of the amplifier (113) and of the captured output signal ($i_{out}(t)$) of the amplifier (113).

2. Method according to claim 1, wherein the emitting (S1) of the gradient pulse ($g_{ref}(t)$) and the capturing (S2) of the gradient sequence ($g_{real}(t)$) take place in a repeating manner, in particular, with a frequency of between one and five repetition intervals of a pulse sequence (PS) of the magnetic resonance scan.

3. Method according to claim 1 or 2, further having the step:

   • establishing (S5.1) a temperature of a gradient coil (6) of the gradient system (9),

   wherein the establishing (S5) of the output signal ($i_{cor}(t)$) of the amplifier (113) takes place dependent upon the temperature of the gradient coil (6).

4. Method according to claim 3, further having the step:

   • establishing (S5.2) a resistance and/or an inductance of the gradient coil (6) of the gradient system (9),

   wherein the establishing (S5.1) of the temperature of the gradient coil (6) takes place dependent upon the resistance and/or the inductance of the gradient coil (6).

5. Method according to one of claims 3 or 4, wherein the establishing (S5.1) of the temperature of the gradient coil (6) takes place dependent upon a model and/or an intelligent algorithm.

6. Method according to one of claims 3 to 5, wherein the establishing (S5.1) of the temperature of the gradient coil (6) takes place dependent upon the captured output signal ($i_{out}(t)$) of the amplifier (113).

7. Method according to one of the preceding claims, wherein the adjustment (S6) of the input signal ($i_{in}(t)$) of the amplifier (113) takes place by means of an adaptive filter, in particular, a Volterra filter, a spline filter and/or a kernel filter.

8. Method according to one of the preceding claims, wherein the emission (S1) of the gradient pulse ($g_{ref}(t)$) comprises an emission of a plurality of gradient pulses ($g_{ref,i}(t)$), and wherein the plurality of gradient pulses ($g_{test,i}(t)$) covers a frequency spectrum of between -20 kHz and +20 kHz, in particular between -10 kHz and +10 kHz.

9. Correcting facility (110), having:

   • an output interface (16) which is designed to emit at least one gradient pulse ($g_{ref}(t)$),
   • an input interface (112) which is designed to capture a gradient sequence ($g_{real}(t)$) captured by means of a magnetic field measurement in an examination region (3) of a magnetic resonance apparatus (2), which becomes established in the examination region (3) by way of the emission of the gradient pulse ($g_{ref}$(t)) and an output signal ($i_{out}$(t)) of an amplifier (113) for the gradient pulse ($g_{ref}$(t)), **characterised by**
• a computer unit (18) which is designed to establish a gradient system transfer function (GSTF, GIRF) and an output signal ($i_{cor}$(t)) of the amplifier (113) dependent upon the captured gradient sequence ($g_{real}$(t)) and the captured output signal ($i_{out}$(t)) of the amplifier (113),

wherein the correcting facility (110) is designed to adjust an input signal ($i_{in}$(t)) of the amplifier (113) dependent upon the established output signal ($i_{cor}$(t)) of the amplifier (113) and the captured output signal ($i_{out}$(t)) of the amplifier (113).

10. Magnetic resonance system (1), comprising a main field magnet system (4), a radio frequency transmitting antenna (5), a gradient system (9), a radio frequency receiving antenna (7) and a correcting facility (110) according to claim 9 and a control unit (13) for actuating the main field magnet systems (4), the radio frequency transmitting antenna (5), the gradient system (9) and the radio frequency receiving antenna (7), wherein the magnetic resonance system (1) is designed to adjust an input signal ($i_{in}$(t)) of an amplifier (113) during a magnetic resonance scan of an examination object by means of the correcting facility (110), in order to provide an expected gradient sequence ($g_{non}$(t)).

11. Computer program product having a computer program which can be loaded directly into a storage device (19) of the control unit (13) of a magnetic resonance system (1) according to claim 10, having program portions in order to carry out all the steps of a method according to one of claims 1 to 8 when the computer program is executed by means of the control unit (13) of the magnetic resonance system (1).

12. Computer-readable medium on which program portions that are able to be read in and executed by a computer unit (18) are stored, in order to carry out all the steps of a method according to one of claims 1 to 8, when the program portions are executed by the computer unit (18).

**Revendications**

1. Procédé de correction de l'impact d'un effet perturbateur sur un système (9) de gradient d'un dispositif (2) de résonnance magnétique lors d'une mesure de résonnance magnétique, comportant les stades :

• émission (S1) d'une impulsion ($g_{ref}$(t)) de gradient au moyen d'un amplificateur (113) du système (9) de gradient,
• détection (S2) d'une courbe ($g_{real}$(t)) de gradient, qui s'établit par l'émission de l'impulsion ($g_{ref}$(t)) de gradient dans une zone (3) d'examen du dispositif (2) de résonnance magnétique, au moyen d'une mesure de champ magnétique dans la zone (3) d'examen,
• détection (S3) d'un signal ($i_{out}$(t)) de sortie de l'amplificateur (113) pour l'impulsion ($g_{ref}$(t)) de gradient,
• détermination (S4) d'une fonction (GSTF, GIRF) de transfert du système de gradient, en fonction de la courbe ($g_{real}$(t)) de gradient détectée et du signal ($i_{out}$(t)) de sortie détecté de l'amplificateur (113), **caractérisé par** les stades
• détermination (S5) d'un signal ($i_{cor}$(t)) de sortie de l'amplificateur (113), dans lequel le système (9) de gradient donne une courbe ($g_{nom}$(t)) de gradient escomptée, en fonction de la fonction (GSTF, GIRF) de transfert de système de gradient déterminée, et
• adaptation (S6) d'un signal ($i_{in}$(t)) d'entrée de l' amplificateur (113), en fonction du signal ($i_{cor}$(t)) de sortie déterminé de l'amplificateur (113) et du signal ($i_{out}$(t)) de sortie détecté de l'amplificateur (113).

2. Procédé suivant la revendication 1, dans lequel l'émission (S1) de l'impulsion ($g_{ref}$(t)) de gradient et la détection (S2) de la courbe ($g_{real}$(t)) de gradient s'effectuent d'une façon récurrente, en particulier avec une fréquence comprise entre un judqu'à cinq intervalles de répétition d'une séquence (PS) d'impulsions de la mesure de résonnance magnétique.

3. Procédé suivant la revendication 1 ou 2, comprenant en outre le stade :

• détermination (S5.1) d'une température d'une bobine (6) de gradient du système (9) de gradient,

dans lequel la détermination (S5) du signal $i_{cor}$(t) de sortie de l'amplificateur (113) s'effectue en fonction de la température de la bobine (6) de gradient.

4. Procédé suivant la revendication 3, comprenant en outre le stade :

   • détermination (S5.2) d'une résistance et/ou d'une induction de la bobine (6) de gradient du système (9) de gradient,

   dans lequel la détermination (S5.1) de la température de la bobine (6) de gradient s'effectue en fonction de la résistance et/ou de l'inductance de la bobine (6) de gradient.

5. Procédé suivant l'une des revendications 3 ou 4, dans lequel la détermination (S5.1) de la température de la bobine (6) de gradient s'effectue en fonction d'un modèle et/ou d'un algorithme intelligent.

6. Procédé suivant l'une des revendications 3 à 5, dans lequel la détermination (5.1) de la température de la bobine (6) de gradient s'effectue en fonction du signal ($i_{out}(t)$) de sortie détecté de l'amplificateur (113).

7. Procédé suivant l'une des revendications précédentes, dans lequel l'adaptation (S6) du signal ($i_{in}(t)$) d'entrée de l'amplificateur (113) s'effectue au moyen d'un filtre adaptatif, en particulier d'un filtre de Volterra, d'un filtre Spline et/ou d'un filtre noyau.

8. Procédé suivant l'une des revendications précédentes, dans lequel l'émission (S1) de l'impulsion ($g_{ref}(t)$) de gradient comprend une émission d'une pluralité d'impulsions ($g_{ref,i}(t)$) de gradient, et dans lequel la pluralité d'impulsions ($g_{test,i}(t)$) de gradient recouvre un spectre de fréquence compris entre - 20 kHz jusqu'à + 20 kHz, en particulier - 10 kHz jusqu'à + 10 kHz.

9. Dispositif (110) de correction, comportant :

   • une interface (16) de sortie, qui est constituée pour émettre au moins une impulsion ($g_{ref}(t)$) de gradient,
   • une interface (112) d'entrée, qui est constituée pour détecter une courbe ($g_{real}(t)$) de gradient, qui est détectée au moyen d'une mesure de champ magnétique dans une zone (3) d'examen d'un dispositif (2) de résonnance magnétique et qui s'établit par une émission de l'impulsion ($g_{ref}(t)$) de gradient dans la zone (3) d'examen, ainsi que pour détecter un signal ($i_{out}(t)$) de sortie d'un amplificateur (113) pour l'impulsion ($g_{ref}(t)$) de gradient, **caractérisé par**
   • une unité (18) informatique, qui est constituée pour déterminer une fonction (GSTF, GIRF) de transfert de système de gradient et un signal ($i_{cor}(t)$) de sortie de l'amplificateur (113), en fonction de la courbe ($g_{real}(t)$) de gradient détectée et du signal ($i_{out}(t)$) de sortie détecté de l'amplificateur (113),

   dans lequel le dispositif (110) de correction est constitué pour adapter un signal ($i_{in}(t)$) d'entrée de l'amplificateur (113), en fonction du signal ($i_{cor}(t)$) de sortie déterminé de l'amplificateur (113) et du signal ($i_{out}(t)$) de sortie détecté de l'amplificateur (113) .

10. Système (1) de résonnance magnétique, comprenant un système (4) magnétique de champ de fond, une antenne (5) d'émission à haute fréquence, un système (9) de gradient, une antenne (7) de réception à haute fréquence et un dispositif (110) de correction suivant la revendication 9 ainsi qu'une unité (13) de commande pour la commande du système (4) magnétique de champ de fond de l'antenne (5) d'émission à haute fréquence, du système (9) de gradient et de l'antenne (7) de réception à haute fréquence, dans lequel le système (1) de résonnance magnétique est constitué pour adapter, au moyen du dispositif (110) de correction, un signal ($i_{in}(t)$) d'entrée d'un amplificateur (113) pendant une mesure de résonnance magnétique d'un objet à examiner, afin de disposer d'une courbe ($g_{nom}(t)$) de gradient escomptée.

11. Produit de programme d'ordinateur comprenant un programme d'ordinateur, qui peut être chargé directement dans une unité (19) de mémoire d'une unité (13) de commande d'un système (1) de résonnance magnétique suivant la revendication 10, comprenant des parties de programme, pour exécuter tous les stades d'un procédé suivant l'une des revendications 1 à 8, lorsque le programme d'ordinateur est exécuté au moyen de l'unité (13) de commande du système (1) de résonnance magnétique.

12. Support, déchiffrable par ordinateur, sur lequel sont mises en mémoire des parties de programme pouvant être déchiffrées et exécutées par une unité (18) informatique, afin d'exécuter tous les stades d'un procédé suivant l'une des revendications 1 à 8, lorsque les parties de programme sont exécutées par l'unité (18) informatique.

FIG 1

FIG 2

FIG 3

FIG 4

# FIG 5

$i_{out}(t)$

$g_{real}(t)$

GSTF

$I_{out}(f)$

$G_{real}(f)$

FT

FT

31a

31b

31c

31d

6

31

EP 4 152 038 B1

FIG 6

S1

S2

S3

S4

S5.1

S5.2

S5

S6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3543722 A1

**In der Beschreibung aufgeführte Nicht-Patentliteratur**

- **NUSSBAUM JENNIFER et al.** Nonlinearity and thermal effects in gradient chains: a cascade analysis based on current and field sensing. *PROCEEDINGS OF THE INTERNATIONAL SOCIETY FOR MAGNETIC RESONANCE IN MEDICINE, ISMRM, 27TH ANNUAL MEETING AND EXHIBITION, MONTREAL, QUEBEC, CANADA, 11 MAY - 16 MAY 2019*, 26 April 2019 (213)
- **RAHMER JÜRGEN et al.** Non-Cartesian k-space trajectory calculation based on concurrent reading of the gradient amplifiers' output currents. *MAGNETIC RESONANCE IN MEDICINE*, 18 February 2021, vol. 85 (6), ISSN 0740-3194, 3060-3070
- Arbitrary magnetic field gradient waveform correction using an impulse response based pre-equalization technique. **GOORA FREDERIC G et al.** JOURNAL OF MAGNETIC RESONANCE. ACADEMIC PRESS, 15 November 2013, vol. 238, 70-76